# EUROPEAN PATENT APPLICATION

(11) **EP 3 873 087 A2**
(43) Date of publication of application: **01.09.2021**
(21) Application number: 21159171.4
(22) Date of filing: 25.02.2021
(51) Int. Cl.: H04N 5/232, G06K 19/07

(54) **IMAGE CAPTURING APPARATUS, DEVICE, CONTROL METHOD, AND PROGRAM**

(30) Priority: 28.02.2020 JP 2020033754
(71) Applicant: CANON KABUSHIKI KAISHA, OHTA-KU Tokyo 146-8501 (JP)
(72) Inventor: ISE, Yasuaki, Ohta-ku, Tokyo 146-8501 (JP)
(74) Representative: TBK

(57) **Abstract**

An image capturing apparatus (110), which includes a mounting part (205) capable of attaching/detaching a device (100) capable of storing at least a captured image, determines, if a device capable of configuring a logic circuit corresponding to analysis processing for data obtained by the image capturing apparatus is mounted in the mounting part, circuit data used to configure the logic circuit of the device based on device information concerning the device, and transmits the determined circuit data to the device.

## Description

### BACKGROUND OF THE INVENTION

### Field of the Invention

The present invention relates to a method of setting an information processing function by a detachable device.

### Description of the Related Art

In recent years, image processing such as image analysis of performing object detection and tracking or performing attribute estimation, and estimation of the number of objects based on the result of such image analysis is performed in various scenes using images captured by a monitoring camera. Conventionally, such image processing has been performed by transferring videos from the monitoring camera to a high performance arithmetic apparatus such as a PC or a server that executes actual image processing. However, the recent improvement of the processing capability of mobile arithmetic apparatuses allows the monitoring camera side to perform image processing (see WO 2016/031720).

WO 2016/031720 describes a system that reduces the load of an arithmetic apparatus by imparting an image processing function to a camera. However, it is not easy to extensionally add a processing function in such an electronic device.

The present invention provides a technique of easily extending a function in an electronic device.

### SUMMARY OF THE INVENTION

The present invention in its first aspect provides an image capturing apparatus as specified in claims 1 to 19.

The present invention in its second aspect provides a device as specified in claims 20 to 34.

The present invention in its third aspect provides a control method as specified in claims 35 to 36.

The present invention in its fourth aspect provides a program as specified in claim 37.

Further features of the present invention will become apparent from the following description of exemplary embodiments (with reference to the attached drawings).

### BRIEF DESCRIPTION OF THE DRAWINGS

Fig. 1 is a block diagram showing an example of a system arrangement;
Fig. 2 is a block diagram showing an example of the hardware arrangement of an image capturing apparatus;
Fig. 3 is a block diagram showing an example of the functional arrangement of the image capturing apparatus;
Fig. 4 is a block diagram showing an example of the hardware arrangement of a detachable device;
Fig. 5 is a block diagram showing an example of the functional arrangement of the detachable device;
Fig. 6 is a block diagram showing an example of the hardware arrangement of an input/output apparatus;
Fig. 7 is a block diagram showing an example of the functional arrangement of the input/output apparatus;
Fig. 8 is a flowchart showing an example of the procedure of processing executed by the system;
Fig. 9 is a flowchart showing an example of the procedure of processing of determining the classification of a mounted device;
Fig. 10 is a view showing an example of the structure of data stored in the detachable device;
Fig. 11 is a flowchart showing an example of the procedure of processing of determining circuit data of a write target;
Fig. 12 is a view showing an example of the structure of data stored in a management apparatus;
Fig. 13 is a flowchart showing an example of the procedure of processing of writing circuit data in the detachable device;
Fig. 14 is a flowchart showing an example of the procedure of control of executing image analysis processing;
Figs. 15A to 15E are views schematically showing examples of the data structure of a command and a response;
Fig. 16 is a flowchart showing an example of the procedure of processing of determining the classification of the detachable device;
Fig. 17 is a flowchart showing an example of the procedure of processing of determining the classification of the detachable device;
Fig. 18 is a block diagram showing another example of the hardware arrangement of the detachable device;
Fig. 19 is a sequence chart showing an example of the procedure of processing executed by the system;
Figs. 20A and 20B are views showing examples of the structure of data stored in the image capturing apparatus;
Fig. 21 is a flowchart showing an example of the procedure of processing of determining circuit data of a write target;
Figs. 22A and 22B are views for explaining processing of determining the classification of the detachable device;
Fig. 23 is a flowchart showing an example of the procedure of processing of determining the classification of the detachable device;
Figs. 24A and 24B are views for explaining processing of determining the classification of the detachable device;
Fig. 25 is a flowchart showing an example of the procedure of processing of determining the classification of the detachable device;
Figs. 26A to 26C are views for explaining processing of determining the classification of the detachable device;
Fig. 27 is a block diagram showing examples of hardware arrangements of the image capturing apparatus and the detachable device;
Fig. 28 is a flowchart showing an example of the procedure of processing of writing circuit data in the detachable device;
Fig. 29 is a flowchart showing an example of the procedure of processing of writing circuit data in the detachable device;
Fig. 30 is a flowchart showing an example of the procedure of processing of writing circuit data in the detachable device; and
Figs. 31A and 31B are views showing an example of signal connection to a terminal of the detachable device.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

### <System Arrangement>

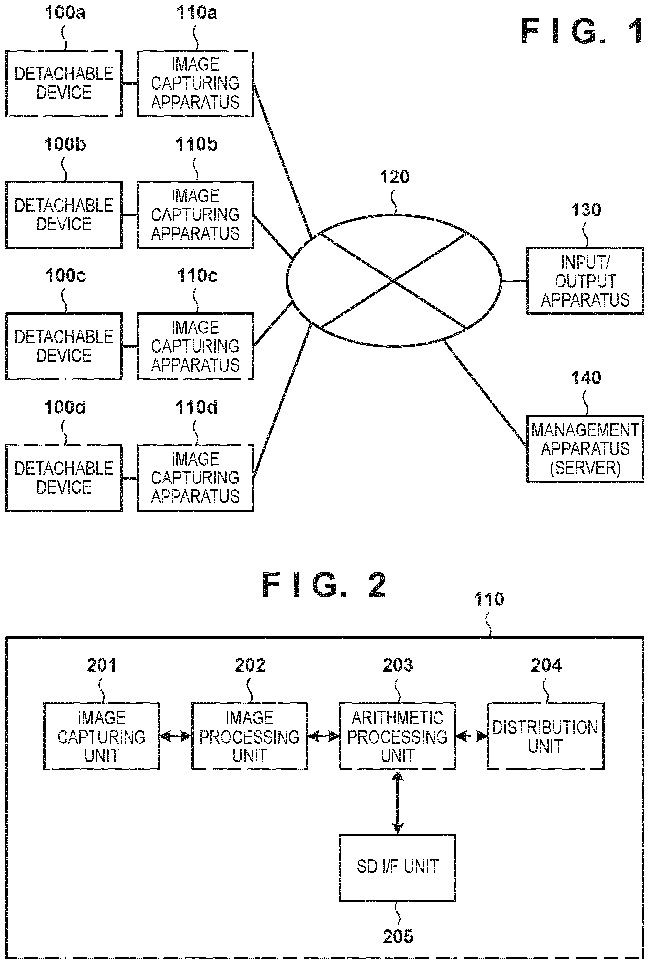

Fig. 1 shows an example of the arrangement of an image analysis system according to this embodiment. As an example, a case in which this system is a specific person tracking system will be described below. However, the present invention is not limited to this, and the following argument can be applied to an arbitrary system for analyzing an image and performing predetermined information output. This system is configured to include image capturing apparatuses 110a to 110d, a network 120, and an input/output apparatus 130. Note that the image capturing apparatuses 110a to 110d each include a slot to/from which a device capable of recording, for example, a captured image can be attached/detached, and when the detachable devices 100a to 100d are inserted into the slots, the image capturing apparatuses 110a to 110d are connected to the detachable devices 100a to 100d. Note that the detachable devices 100a to 100d will be referred to as "detachable devices 100", and the image capturing apparatuses 110a to 110d will be referred to as "image capturing apparatuses 110" hereinafter.

The detachable device 100 is an arithmetic device attachable/detachable to/from the image capturing apparatus 110. As an example, the detachable device 100 is a device with a predetermined processing circuit mounted in an SD card. The detachable device 100 is configured to be inserted as a whole into the image capturing apparatus 110 in a form of, for example, an SD card, and can therefore be configured to be connectable to the image capturing apparatus 110 without making any portion project from the image capturing apparatus 110. Alternatively, the detachable device 100 may be configured such that, for example, a half or more of it can be inserted into the image capturing apparatus 110, and may therefore be configured to be connectable to the image capturing apparatus 110 while making a portion project a little from the image capturing apparatus 110. This can prevent the detachable device 100 from interfering with an obstacle such as a wiring and raise the convenience when using the device. In addition, since an SD card slot is prepared in a lot of existing image capturing apparatuses 110 such as a network camera, the detachable device 100 can provide an extension function to the existing image capturing apparatus 110. Note that other than the form of an SD card, the detachable device 100 may be configured to be mounted in the image capturing apparatus 110 via an arbitrary interface used when mounting a storage device capable of storing an image captured by at least the image capturing apparatus 110. For example, the detachable device 100 may include a USB (Universal Serial Bus) interface, and may be configured to be mounted in a USB socket of the image capturing apparatus 110. The predetermined processing circuit is implemented by, for example, an FPGA (Field Programmable Gate Array) programmed to execute predetermined processing but may be implemented in another form.

The image capturing apparatus 110 is an image capturing apparatus such as a network camera. In this embodiment, the image capturing apparatus 110 incorporates an arithmetic apparatus capable of processing a video but is not limited to this. For example, an external computer such as a PC (Personal Computer) connected to the image capturing apparatus 110 may exist, and the combination may be handled as the image capturing apparatus 110. Additionally, in this embodiment, the detachable devices 100 are mounted in all the image capturing apparatuses 110. Note that Fig. 1 shows four image capturing apparatuses 110, and the detachable devices mounted in these. The number of combinations of devices may be three or less, or five or more. When the detachable device 100 having an image analysis processing function is mounted in the image capturing apparatus 110, video processing can be executed on the side of the image capturing apparatus 110 even if the image capturing apparatus 110 does not have the image analysis processing function. Also, in a form in which an arithmetic apparatus for video processing is arranged in the image capturing apparatus 110, as in this embodiment, image processing executable on the side of the image capturing apparatus 110 can be diversified/sophisticated by mounting the detachable device 100 including an arithmetic apparatus in the image capturing apparatus 110.

The input/output apparatus 130 is an apparatus that performs acceptance of input from a user and output of information (for example, display of information) to the user. In this embodiment, for example, the input/output apparatus 130 is a computer such as a PC, and information is input/output by a browser or a native application installed in the computer.

A management apparatus 140 is a management server that holds various kinds of data. The management apparatus 140 can be configured to, for example, transmit/receive data in response to a request from the image capturing apparatus 110 or the input/output apparatus 130. The management apparatus 140 can also be configured to manage authentication processing and information at the time of authentication.

The image capturing apparatuses 110, the input/output apparatus 130, and the management apparatus 140 are communicably connected to each other via the network 120. The network 120 is configured to include a plurality of routers, switches, cables, and the like, which satisfy the communication standard of, for example, Ethernet®. In this embodiment, the network 120 can be an arbitrary network that enables communication between the image capturing apparatus 110 and the input/output apparatus 130, and can be constructed by an arbitrary scale and arrangement and a communication standard to comply with. For example, the network 120 can be the Internet, a wired LAN (Local Area Network), a wireless LAN, a WAN (Wide Area Network), or the like. The network 120 can be configured such that, for example, communication by a communication protocol complying with the ONVIF (Open Network Video Interface Forum) standard is possible. However, the network 120 is not limited to this and may be configured such that, for example, communication by another communication protocol such as a unique communication protocol is possible.

### <Apparatus Arrangement>

### (Arrangement of Image Capturing Apparatus)

The arrangement of the image capturing apparatus 110 will be described next. Fig. 2 is a block diagram showing an example of the hardware arrangement of the image capturing apparatus 110. As the hardware arrangement, the image capturing apparatus 110 includes, for example, an image capturing unit 201, an image processing unit 202, an arithmetic processing unit 203, a distribution unit 204, and an SD I/F unit 205. Note that I/F is an abbreviation of interface.

The image capturing unit 201 is configured to include a lens portion configured to form an image of light, and an image capturing element that performs analog signal conversion according to the formed image of light. The lens portion has a zoom function of adjusting an angle of view, a stop function of adjusting a light amount, and the like. The image capturing element has a gain function of adjusting sensitivity when converting light into an analog signal. These functions are adjusted based on set values notified from the image processing unit 202. The analog signal obtained by the image capturing unit 201 is converted into a digital signal by an analog-to-digital conversion circuit and transferred to the image processing unit 202 as an image signal.

The image processing unit 202 is configured to include an image processing engine, and peripheral devices thereof. The peripheral devices include, for example, a RAM (Random Access Memory), the drivers of I/Fs, and the like. The image processing unit 202 performs, for example, image processing such as development processing, filter processing, sensor correction, and noise removal for the image signal obtained from the image capturing unit 201, thereby generating image data. The image processing unit 202 can also transmit set values to the lens portion and the image capturing element and execute exposure adjustment to obtain an appropriately exposed image. The image data generated by the image processing unit 202 is transferred to the arithmetic processing unit 203.

The arithmetic processing unit 203 is formed by at least one processor such as a CPU or an MPU, memories such as a RAM and a ROM, the drivers of I/Fs, and the like. Note that CPU is the acronym of Central Processing Unit, MPU is the acronym of Micro Processing Unit, RAM is the acronym of Random Access Memory, and ROM is the acronym of Read Only Memory. In an example, the arithmetic processing unit 203 can determine allocation concerning which one of the image capturing apparatus 110 and the detachable device 100 should execute each portion of processing to be executed in the above-described system, and execute processing corresponding to the allocation. Details of processing contents and processing allocation will be described later. The image received from the image processing unit 202 is transferred to the distribution unit 204 or the SD I/F unit 205. The data of the processing result is also transferred to the distribution unit 204.

The distribution unit 204 is configured to include a network distribution engine and, for example, peripheral devices such as a RAM and an ETH PHY module. The ETH PHY module is a module that executes processing of the physical (PHY) layer of Ethernet. The distribution unit 204 converts the image data or the data of the processing result obtained from the arithmetic processing unit 203 into a format distributable to the network 120, and outputs the converted data to the network 120. The SD I/F unit 205 is an interface portion used to connect the detachable device 100, and is configured to include, for example, a power supply, and a mounting part such as an attaching/detaching socket used to attach/detach the detachable device 100. Here, the SD I/F unit 205 is configured in accordance with the SD standard formulated by the SD Association. Communication between the detachable device 100 and the image capturing apparatus 110, such as transfer of an image obtained from the arithmetic processing unit 203 to the detachable device 100 or data obtaining from the detachable device 100, is performed via the SD I/F unit 205.

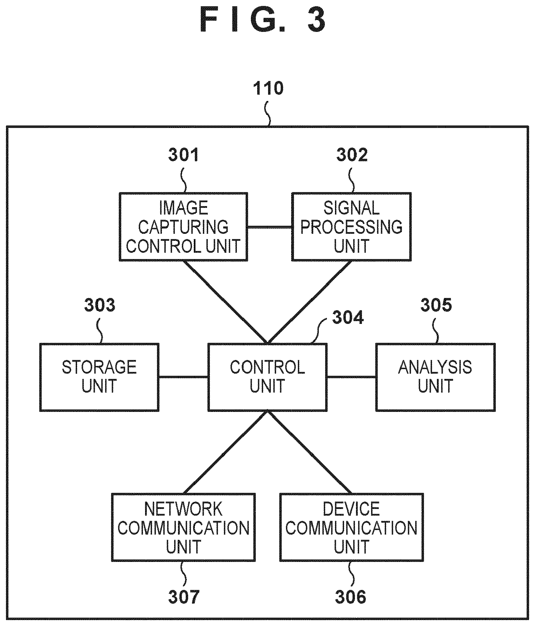

Fig. 3 shows an example of the functional arrangement of the image capturing apparatus 110. The image capturing apparatus 110 includes, as its functions, for example, an image capturing control unit 301, a signal processing unit 302, a storage unit 303, a control unit 304, an analysis unit 305, a device communication unit 306, and a network communication unit 307.

The image capturing control unit 301 executes control of capturing the peripheral environment via the image capturing unit 201. The signal processing unit 302 performs predetermined processing for the image captured by the image capturing control unit 301, thereby generating data of the captured image. The data of the captured image will simply be referred to as the "captured image" hereinafter. The signal processing unit 302, for example, encodes the image captured by the image capturing control unit 301. The signal processing unit 302 performs encoding for a still image using, for example, an encoding method such as JPEG (Joint Photographic Experts Group). The signal processing unit 302 performs encoding for a video using an encoding method such as H.264/MPEG-4 AVC (to be referred to as "H.264" hereinafter) or HEVC (High Efficiency Video Coding). The signal processing unit 302 may encode an image using an encoding method selected by the user from a plurality of encoding methods set in advance via, for example, an operation unit (not shown) of the image capturing apparatus 110.

The storage unit 303 stores a list (to be referred to as a "first processing list" hereinafter) of analysis processing executable by the analysis unit 305 and a list of post-processes for a result of analysis processing. The storage unit 303 also stores a result of analysis processing to be described later. Note that in this embodiment, processing to be executed is analysis processing. However, arbitrary processing may be executed, and concerning processing associated with the processing to be executed, the storage unit 303 may store the first processing list and the list of post-processes. The control unit 304 controls the signal processing unit 302, the storage unit 303, the analysis unit 305, the device communication unit 306, and the network communication unit 307 to execute predetermined processing.

The analysis unit 305 selectively executes at least one of pre-analysis processing, analysis processing, and post-analysis processing to be described later for a captured image. Pre-analysis processing is processing to be executed for a captured image before analysis processing to be described later is executed. In the pre-analysis processing according to this embodiment, as an example, processing of dividing a captured image to create divided images is executed. Analysis processing is processing of outputting information obtained by analyzing an input image. In the analysis processing according to this embodiment, as an example, processing of receiving a divided image obtained by pre-analysis processing, executing at least one of human body detection processing, face detection processing, and vehicle detection processing, and outputting the analysis processing result is executed. The analysis processing can be processing configured to output the position of an object in a divided image using a machine learning model that has learned to detect an object included in an image. It is possible to perform analysis processing using a method described in, for example, J. Redmon and A. Farhadi "YOL09000: Better Faster Stronger" Computer Vision and Pattern Recognition (CVPR) 2016.

Note that post-analysis processing is processing to be executed after analysis processing is executed. In the post-analysis processing according to this embodiment, as an example, processing of outputting, as a processing result, a value obtained by adding the numbers of objects detected in the divided images based on the analysis processing result for each divided image is executed. Note that the analysis processing may be processing of detecting an object in an image by performing pattern matching and outputting the position of the object.

The device communication unit 306 performs communication with the detachable device 100. The device communication unit 306 converts input data into a format processible by the detachable device 100, and transmits data obtained by the conversion to the detachable device 100. In addition, the device communication unit 306 receives data from the detachable device 100, and converts the received data into a format processible by the image capturing apparatus 110. In this embodiment, as the conversion processing, the device communication unit 306 executes processing of converting a decimal between a floating point format and a fixed point format. However, the present invention is not limited to this, and another process may be executed by the device communication unit 306. Additionally, in an example, the device communication unit 306 transmits a command sequence determined in advance within the range of the SD standard to the detachable device 100, and receives a response from the detachable device 100, thereby performing communication with the detachable device 100. The network communication unit 307 performs communication with the input/output apparatus 130 via the network 120.

### (Arrangement of Detachable Device)

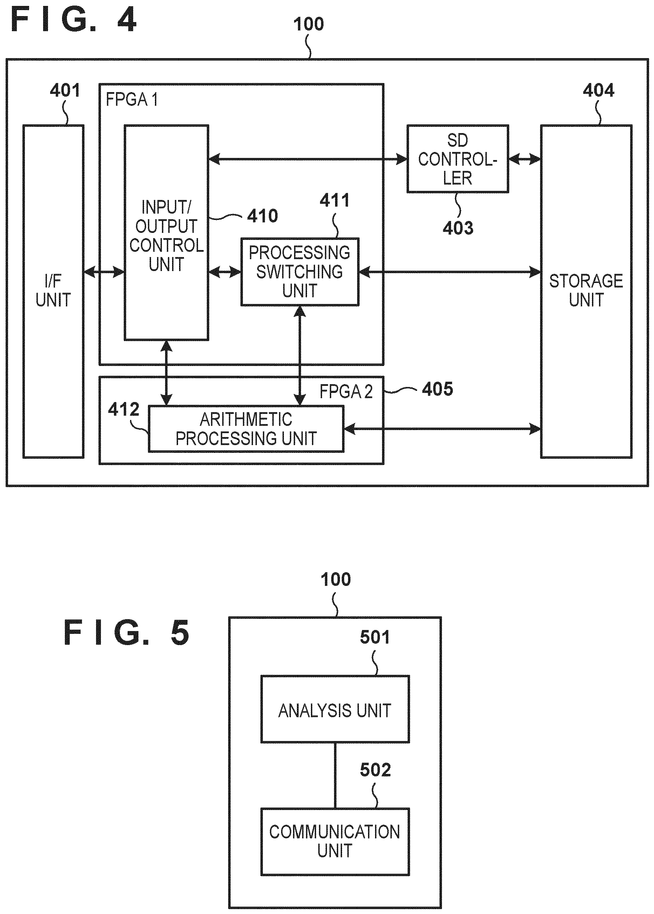

Fig. 4 is a block diagram showing an example of the hardware arrangement of the detachable device 100. As an example, the detachable device 100 is configured to include an I/F unit 401, an FPGA 402, an SD controller 403, a storage unit 404, and an FPGA 405. The detachable device 100 is formed into a shape that can be inserted/removed into/from the attaching/detaching socket of the SD I/F unit 205 provided in the image capturing apparatus 110, that is, a shape complying with the SD standard.

The I/F unit 401 is an interface portion used to connect an apparatus such as the image capturing apparatus 110 and the detachable device 100. The I/F unit 401 is configured to include, for example, an electrical contact terminal that receives supply of power from the image capturing apparatus 110 and generates and distributes a power supply to be used in the detachable device 100, and the like. Concerning items defined in (complying with) the SD standard, the I/F unit 401 complies with that, like the SD I/F unit 205 of the image capturing apparatus 110. Reception of images and setting data from the image capturing apparatus 110 and transmission of data from the FPGA 402 to the image capturing apparatus 110 are executed via the I/F unit 401.

The FPGA 402 and the FPGA 405 are configured to include an input/output control unit 410, a processing switching unit 411, and an arithmetic processing unit 412. Each of the FPGA 402 and the FPGA 405 is a kind of semiconductor device capable of repetitively reconfiguring (reconstructing) an internal logic circuit structure. Note that "reconfiguration" in each embodiment includes transition from a state in which a logic circuit is not configured (constructed) to a state in which a logic circuit is configured (constructed). That is, reconfiguration includes processing other than transition from a state in which a certain logic circuit is configured to a state in which another logic circuit is configured. By processing implemented by the FPGA 402 and the FPGA 405, a processing function can be added (provided) to the apparatus in which the detachable device 100 is mounted. Additionally, the logic circuit structure can be changed later by the reconfiguration function of the FPGA 402 and the FPGA 405. For this reason, when the detachable device 100 is mounted in, for example, an apparatus in a field of a quickly advancing technology, appropriate processing can be executed in the apparatus at an appropriate timing. Note that in this embodiment, an example in which an FPGA is used will be described. However, for example, a general-purpose ASIC or a dedicated LSI may be used if processing to be described later can be implemented. The FPGA 402 and the FPGA 405 are activated by writing, from a dedicated I/F, setting data including the information of a logic circuit structure to be generated or reading out the setting data from the dedicated I/F.

In this embodiment, the setting data of the FPGA 405, which forms the analysis processing function, is not held in the storage unit 404 and is written from the image capturing apparatus 110. On the other hand, the FPGA 402 can be configured to read out the setting data from the storage unit 404 or a storage unit (not shown), generate a logic circuit, and activate it when the device is powered on. However, the present invention is not limited to this. For example, by implementing a dedicated circuit in the detachable device 100, the FPGA 402 may be activated/operated based on setting data written from the image capturing apparatus 110 via the I/F unit 401. The FPGA 402 and the FPGA 405 may be formed by one FPGA. Additionally, the functional portion of the FPGA 402 may be formed using a dedicated circuit, and only the functional portion of the FPGA 405 may be formed by a reconfigurable FPGA or another reconfigurable logic circuit device.

The input/output control unit 410 is configured to include a circuit used to transmit/receive an image to/from the image capturing apparatus 110, a circuit that analyzes a command received from the image capturing apparatus 110, a circuit that controls based on a result of analysis, and the like. Commands here can include commands of structures defined by the SD standard. Details of the functions will be described later. The input/output control unit 410 controls to transmit an image to the SD controller 403 in storage processing and transmit an image to the arithmetic processing unit 412 in image analysis processing. If the setting data of switching of processing is received, the input/output control unit 410 transmits the setting data to the processing switching unit 411.

The processing switching unit 411 is configured to include a circuit configured to obtain the information of the image analysis processing function from the storage unit 404 based on the setting data received from the image capturing apparatus 110 and write the information in the arithmetic processing unit 412. The information of the image analysis processing function is, for example, analysis processing circuit data configured in the arithmetic processing unit 412. The analysis processing circuit data can include setting parameters representing the order and types of operations to be processed, the coefficients of operations, and the like.

The arithmetic processing unit 412 is configured to include a plurality of arithmetic circuits needed to execute the image analysis processing function. The arithmetic processing unit 412 executes each arithmetic processing based on the information of the image analysis processing function received from the processing switching unit 411, transmits the processing result to the image capturing apparatus 110, and/or records the processing result in the storage unit 404. The FPGA 405 can change processing contents to be executed by the arithmetic processing unit 412 by analysis processing circuit data written from the image capturing apparatus 110 and setting data corresponding to an execution target processing function set in the analysis processing circuit. This allows the detachable device 100 to selectively execute at least one of processes corresponding to a plurality of analysis processing circuit data held by the image capturing apparatus 110. Note that when the setting data of necessary processing is written in the FPGA 405 any time, for example, latest processing just developed can be executed by the image capturing apparatus 110 in which the detachable device 100 is mounted. Note that holding a plurality of setting data corresponding to a plurality of processing functions will be expressed as "holding a plurality of processing functions" hereinafter. That is, for example, even in a state in which the FPGA 405 is configured to execute one processing function, if the processing contents of the arithmetic processing unit 412 can be changed by setting data for another processing function, this is expressed as "a plurality of processing functions can be executed".

The SD controller 403 is a known control IC (Integrated Circuit) as defined by the SD standard, and executes control of a slave operation of an SD protocol and control of data read/write for the storage unit 404. The storage unit 404 is formed by, for example, a NAND flash memory, and stores various kinds of information such as storage data written from the image capturing apparatus 110, the information of the image analysis processing function written in the arithmetic processing unit 412, and setting data of the FPGA 402.

Fig. 5 shows an example of the functional arrangement of the detachable device 100. The detachable device 100 includes, as its functional arrangement, for example, an analysis unit 501 and a communication unit 502. The analysis unit 501 executes analysis processing for, for example, an image or audio data. For example, if an analysis processing setting request is input, the analysis unit 501 executes setting to set the input analysis processing in an executable state. If an image is input, the analysis unit 501 executes the analysis processing set in the executable state for the input image. In this embodiment, executable analysis processing includes human body detection processing and face detection processing but is not limited to these. For example, it may be processing (face authentication processing) of determining whether a person stored in advance is included in an image. For example, if the degree of matching between the image feature of a person stored in advance and the image feature of a person detected from an input image is calculated, and the degree of matching is equal to or larger than a threshold, it is determined that the person is the person stored in advance. Alternatively, it may be processing of superimposing a predetermined mask image or performing mosaic processing on a person detected from an input image for the purpose of privacy protection. It may be processing of detecting, using a learning model that has learned a specific action of a person by machine learning, whether a person in an image is taking the specific action. Furthermore, it may be processing of determining what kind of region a region in an image is. It may be processing of determining, using, for example, a learning model that has learned buildings, roads, persons, sky and the like by machine learning, what kind of region a region in an image is. As described above, executable analysis processing can be applied to both image analysis processing using machine learning and image analysis processing without using machine learning. Each analysis processing described above may be executed not independently by the detachable device 100 but in cooperation with the image capturing apparatus 110. The communication unit 502 performs communication with the image capturing apparatus 110 via the I/F unit 401.

### (Arrangement of Input/Output Apparatus)

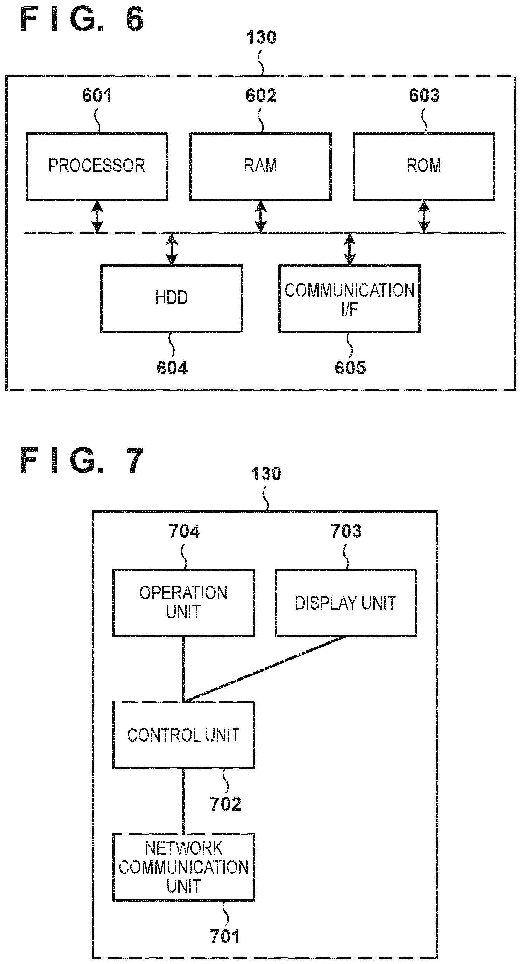

Fig. 6 shows an example of the hardware arrangement of the input/output apparatus 130. The input/output apparatus 130 is formed as a computer such as a general PC, and is configured to include, for example, a processor 601 such as a CPU, memories such as a RAM 602 and a ROM 603, a storage device such as an HDD 604, and a communication I/F 605, as shown in Fig. 6. The input/output apparatus 130 can execute various kinds of functions by executing, by the processor 601, programs stored in the memories and the storage device.

Fig. 7 shows an example of the functional arrangement of the input/output apparatus 130 according to this embodiment. The input/output apparatus 130 includes, as its functional arrangement, for example, a network communication unit 701, a control unit 702, a display unit 703, and an operation unit 704. The network communication unit 701 is connected to, for example, the network 120 and executes communication with an external apparatus such as the image capturing apparatus 110 via the network 120. Note that this is merely an example and, for example, the network communication unit 701 may be configured to establish direct communication with the image capturing apparatus 110 and communicate with the image capturing apparatus 110 without intervention of the network 120 or other apparatus. The control unit 702 controls such that the network communication unit 701, the display unit 703, and the operation unit 704 execute processing of their own. The display unit 703 presents information to the user via, for example, a display. In this embodiment, a result of rendering by a browser is displayed on a display, thereby presenting information to the user. Note that information may be presented by a method such as an audio or a vibration other than screen display. The operation unit 704 accepts an operation from the user. In this embodiment, the operation unit 704 is a mouse or a keyboard, and the user operates these to input a user operation to the browser. However, the operation unit 704 is not limited to this and may be, for example, another arbitrary device capable of detecting a user's intention, such as a touch panel or a microphone.

### <Procedure of Processing>

An example of the procedure of processing executed in the system will be described next. Note that processing executed by the image capturing apparatus 110 in the following processes is implemented by, for example, by a processor in the arithmetic processing unit 203, executing a program stored in a memory or the like. However, this is merely an example, and processing to be described later may partially or wholly be implemented by dedicated hardware. In addition, processing executed by the detachable device 100 or the input/output apparatus 130 may also be implemented by, by a processor in each apparatus, executing a program stored in a memory or the like, and processing may partially or wholly be implemented by dedicated hardware.

### (Overall Procedure)

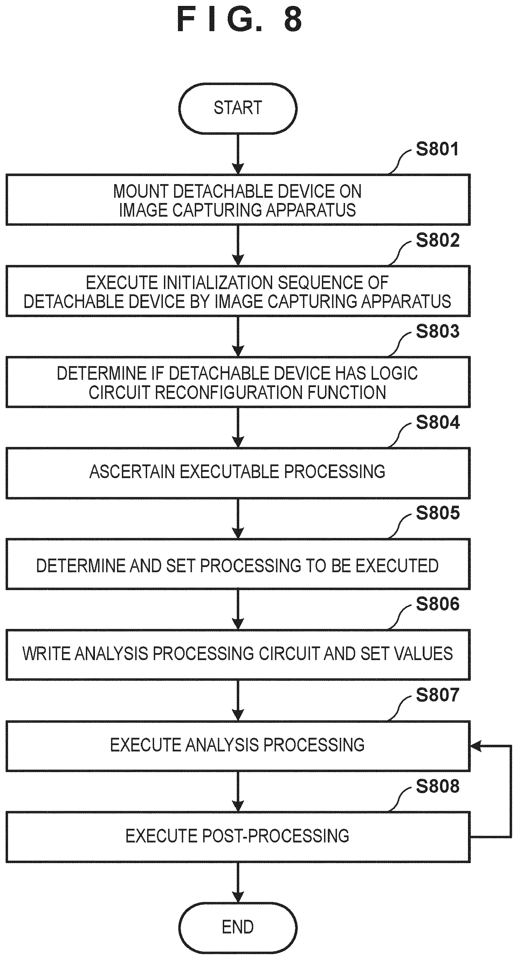

Fig. 8 schematically shows a series of procedures of image analysis processing executed by the system. In this processing, first, the user mounts the detachable device 100 in the image capturing apparatus 110 (step S801). The image capturing apparatus 110 executes an initialization sequence of the detachable device 100 (step S802). In this initialization sequence, the image capturing apparatus 110 supplies power to the detachable device 100, and predetermined commands are transmitted/received between the image capturing apparatus 110 and the detachable device 100. The image capturing apparatus 110 thus makes the detachable device 100 usable.

After that, the image capturing apparatus 110 determines whether the detachable device 100 has a logic circuit reconfiguration function capable of configuring an analysis processing function (step S803). If the detachable device 100 has the logic circuit reconfiguration function capable of configuring an analysis processing function, the image capturing apparatus 110 also determines whether circuit data needs to be written in the detachable device 100. Upon determining that circuit data needs to be written, the image capturing apparatus 110 obtains the configuration information (to be also referred to as "device information" hereinafter) of the detachable device 100, and determines circuit data according to the device information. Device information concerning the detachable device 100 includes, for example, FPGA information that configures the analysis processing function, connection information to peripheral circuits, and the like. Note that the determination of the necessity of the write of circuit data and the determination of circuit data according to device information may be performed after processing to be executed by the detachable device 100 is determined as will be described later.

Next, the image capturing apparatus 110 ascertains processing executable by the detachable device 100, and ascertains processing that can be executed locally (that can be executed only by the image capturing apparatus 110 or by the combination of the image capturing apparatus 110 and the detachable device 100) (step S804). Note that although the detachable device 100 can be configured to execute arbitrary processing, processing irrelevant to processing that should be executed on the side of the image capturing apparatus 110 need not be taken into consideration. Next, the image capturing apparatus 110 determines processing to be executed (step S805), determines circuit data to be written in the detachable device 100 as needed, and writes setting data including circuit information and set values in the detachable device 100 (step S806). For example, if at least part of processing determined as an execution target is to be executed by the detachable device 100, and circuit data for the processing is not written in the detachable device 100, the image capturing apparatus 110 determines that the write of circuit data is needed. If the image capturing apparatus 110 determines that the write of circuit data is needed, setting data including circuit data of a portion to be executed by the detachable device 100 in the processing determined as the execution target is written from the image capturing apparatus 110 to the detachable device 100. Note that if the circuit itself need not be rewritten, setting data that does not include circuit data may be written. By this setting, for example, reconfiguration of the FPGA 405 using setting data corresponding to the processing of the execution target can be performed. Then, the image capturing apparatus 110 or the detachable device 100 executes analysis processing (step S807). After that, the image capturing apparatus 110 executes post-processing (step S808). Note that the processes of steps S807 and S808 are repetitively executed. The processing shown in Fig. 8 is executed when, for example, the detachable device 100 is mounted. However, at least part of the processing shown in Fig. 8 may repetitively be executed such that, for example, the process of step S802 is executed again when the detachable device 100 is powered on again.

Such a method of mounting the detachable device 100 to the image capturing apparatus 110 and extending processing (analysis processing) executable on the side of the image capturing apparatus 110 is a method usable if the detachable device 100 has the logic circuit reconfiguration function capable of configuring an analysis processing function. On the other hand, an SD card serving as a general storage medium that does not have such a logic circuit reconfiguration function is sometimes inserted into the image capturing apparatus 110. Such an SD card cannot be caused to execute processing even if the image capturing apparatus 110 writes circuit data, as a matter of course. It can also be assumed that, for example, a device that can be connected to the image capturing apparatus 110 via the SD I/F and implements only the logic circuit reconfiguration function is mounted. If such a device is mounted, for example, even if the image capturing apparatus 110 is to store image data obtained by image capturing, the device may not have a function of storing such image data. Also, if the mounted device has the logic circuit reconfiguration function, reconfiguration of an appropriate circuit is required in accordance with the configuration of the reconfiguration function, and the like. This is because if a circuit that is not appropriate for the configuration of the reconfiguration function is reconfigured, this may cause efficiency degradation such as unnecessary power consumption or may cause an operation error in some cases. As described above, various devices can be mounted in a device mounting part such as an SD card slot of the image capturing apparatus 110. In accordance with the mounted device, the image capturing apparatus 110 needs to appropriately control, for example, whether to cause the device to execute the analysis processing function or execute a storage processing function.

In this embodiment, considering such a situation, the image capturing apparatus 110 specifies information representing whether the mounted device has the logic circuit reconfiguration function or information concerning the device such as the reconfiguration function, and executes appropriate control according to the mounted device. Several examples of the processing will be described below.

### (Processing Example 1)

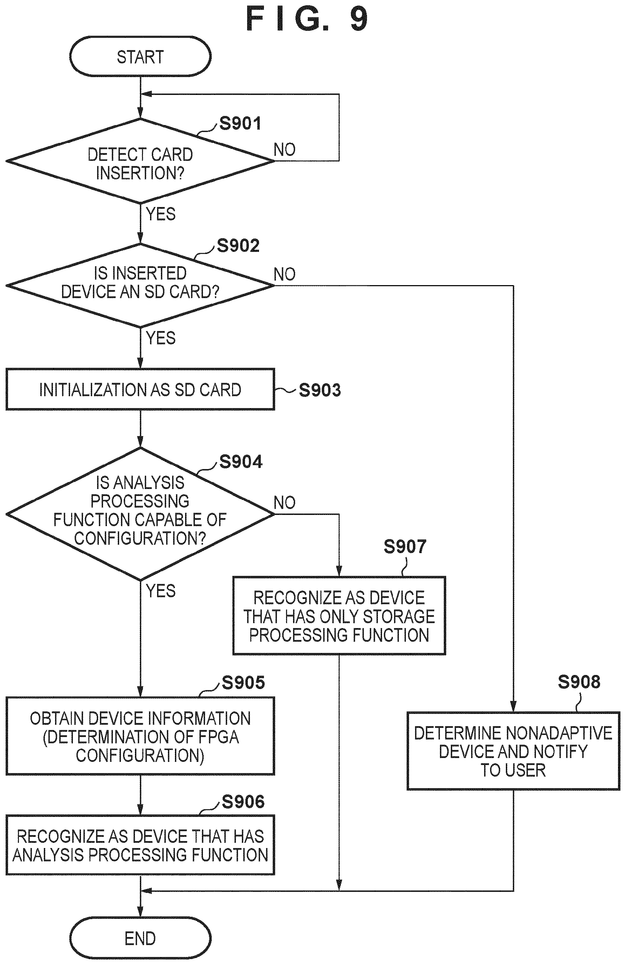

An example of the procedure of processing of classifying a device by determining, by the image capturing apparatus 110, whether a device mounted in the self-apparatus has a logic circuit reconfiguration function capable of configuring an analysis processing function will be described with reference to Fig. 9. This processing corresponds to the process of step S803 in Fig. 8. Note that this processing can be executed when a device such as the detachable device 100 is mounted in or removed from the image capturing apparatus 110 or when the image capturing apparatus 110 is powered on. In this processing, the image capturing apparatus 110 reads out the device information of the detachable device 100, which is stored in the storage unit 404 of the detachable device 100, and determines the type of the detachable device 100.

First, the image capturing apparatus 110 determines whether an external device is mounted in the mounting part capable of attaching/detaching the detachable device 100. That is, the control unit 304 of the image capturing apparatus 110 determines whether an SD card is inserted in the SD card slot (step S901). Upon determining that an external device is not mounted (NO in step S901), the control unit 304 waits for mounting of an external device. On the other hand, upon determining that an external device is mounted (YES in step S901), the control unit 304 tries communication complying with the SD standard via the SD I/F unit 205, and determines whether the mounted device is an SD card (step S902). Note that, for example, if the mounted device has a function of performing communication as an SD card, the control unit 304 determines that the device is an SD card. That is, if a device that is in an arbitrary form and has an SD card function is mounted, the device is recognized as an SD card. Upon determining that the mounted device is an SD card (YES in step S902), the control unit 304 executes an initialization operation as an SD card between the device and the self-apparatus (step S903). On the other hand, if the inserted device is not an SD card (NO in step S902), the control unit 304 determines that it is a nonadaptive device, notifies the user of it (step S908), and ends the processing.

Next, the control unit 304 of the image capturing apparatus 110 determines whether the mounted external device is, for example, a device having only a conventional storage processing function or a device having a logic circuit reconfiguration function capable of configuring a specific processing function (step S904). For example, the control unit 304 controls the device communication unit 306 to issue a read request (read command) for a specific address to the mounted device and read out flag data stored at the specific address. The specific address will sometime be referred to as an "address A" hereinafter. Note that details of the data stored at the address A will be described later. The control unit 304 can determine, based on the read flag data, whether the detachable device 100 is a device having a logic circuit reconfiguration function capable of configuring a specific processing function. However, this is merely an example, and it may be determined by another method whether the mounted device is a predetermined device having a logic circuit reconfiguration function. If the mounted device is not a predetermined device (NO in step S904), the control unit 304 determines that the mounted device is a device having only a storage function (step S907), and ends the processing. For example, if no data is stored as the address A, or the flag data stored at the address A indicates that the mounted device is not a predetermined device, the control unit 304 determines that the mounted device is not a predetermined device.

Upon determining that the mounted device is a predetermined device (YES in step S904), the control unit 304 executes processing for ascertaining circuit data that can be written in the device (detachable device 100). The control unit 304 controls the device communication unit 306 to communicate with the detachable device 100 and obtain the device information of the detachable device 100 (step S905). For example, the device information can be stored at the same address (address A) as the flag data used to determine whether the detachable device is a predetermined device. In this case, as in a case in which the control unit 304 determines whether the detachable device 100 is a predetermined device, the control unit 304 can obtain the device information by reading out data stored at the address A. In this case, the image capturing apparatus 110 accesses the address A, thereby simultaneously obtaining the flag data and the device information and simultaneously executing the process of step S902 and the process of step S905. However, the present invention is not limited to this, and these data may be stored at different addresses. Based on the device information, the control unit 304 specifies analysis circuit data that can be written in the detachable device 100. For example, the control unit 304 determines whether the detachable device 100 can implement each of one or more analysis circuit data that can be provided from the image capturing apparatus 110 to the detachable device 100. The control unit 304 determines, based on the determination result, whether the detachable device 100 can execute analysis processing, and specifies executable analysis processing (step S906). Note that as a list of analysis processes executable by the detachable device 100, information representing a list of analysis processes associated with the analysis circuit data that can be written in the detachable device 100 may be included in the device information. Hence, the image capturing apparatus 110 can ascertain processing executable by the detachable device 100 by obtaining the device information.

With the above-described processing, if the detachable device 100 capable of executing specific processing is mounted in the image capturing apparatus 110, the image capturing apparatus 110 can determine whether to write the specific processing in the detachable device 100. In addition, the image capturing apparatus 110 can select circuit data suitable for the detachable device 100 by obtaining device information. Furthermore, for example, when the image capturing apparatus 110 notifies the input/output apparatus 130 of the determination result, the determination result can be presented to the user, and the user can recognize whether a correct device is mounted in the image capturing apparatus 110.

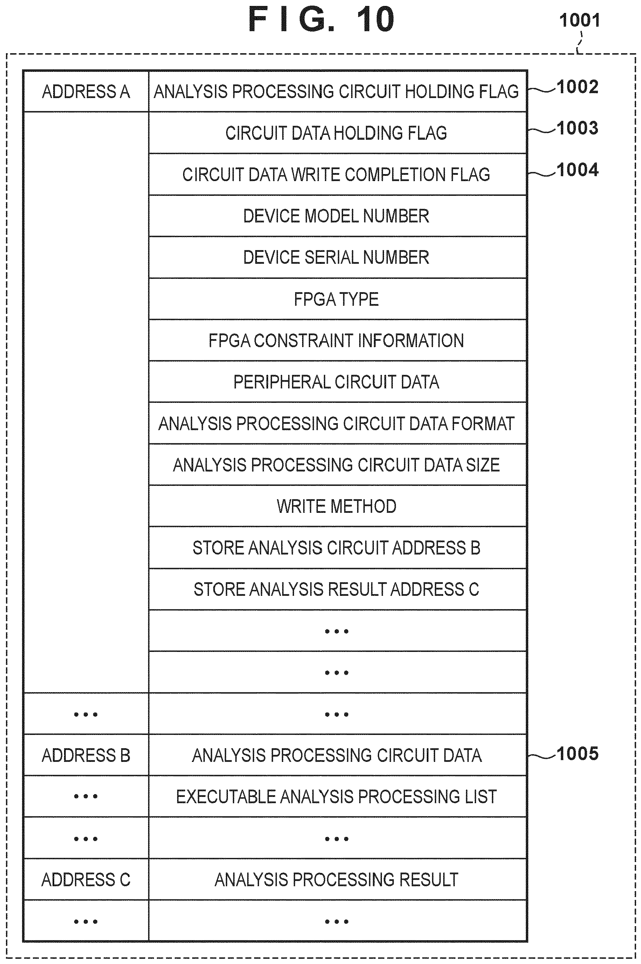

An example of information 1001 stored in the storage unit 404 of the detachable device 100 will be described here with reference to Fig. 10. The detachable device 100 according to this embodiment stores device information held by the self-apparatus at a specific address (address A) of the storage unit 404. The control unit 304 of the image capturing apparatus 110 issues a multi-read command or a single-read command for the address A, thereby confirming the device information of the detachable device 100. The device information includes, for example, an analysis processing circuit holding flag 1002 representing whether the device has a logic circuit reconfiguration function capable of configuring an analysis processing function. The device information can also include a circuit data holding flag 1003 representing whether write of circuit data is necessary, and a circuit data write completion flag 1004 representing whether write of circuit data in the arithmetic processing circuit is completed. Also, the device information can include the data format of circuit data to be written, a write command, and the processing time of circuit write processing as the configuration information of the hardware of the detachable device 100. The configuration information of the hardware can include, for example, the type (model number) of the FPGA, constraint information representing PIN connection of the FPGA, the constraint information of the logic circuit arrangement, terminal connection information, and information representing peripheral circuit devices. Note that if these pieces of information are stored in advance in a database in association with information such as a model number, a serial number, and an ID number, the model number, the serial number, the ID number, and the like may be included as the configuration information of the hardware. Other pieces of information may also be replaced with other pieces of information capable of specifying the same type of information. Also, the device information may also include a processing function list after the implementation of analysis processing, a time needed until the completion of analysis processing if it is executed, the data size of a processing result, the information of an address for storing the processing result, and the like.

Note that the device information may be stored in the storage unit 404 in an encrypted state. In this case, the image capturing apparatus 110 obtains the encrypted information and decrypts the obtained information, thereby obtaining the device information. Alternatively, the image capturing apparatus may have an authentication function and may be configured to be inhibited from reading the device information from the storage unit 404 without using specific key information.

For example, analysis processing circuit data to be written in the arithmetic processing unit 412 is stored at an address B of the storage unit 404, which is different from the address A. For example, in the detachable device 100, when an analysis processing setting command used to activate the analysis processing function is received from the image capturing apparatus 110, the processing switching unit 411 reads out the analysis processing circuit data at the address B, and write in the arithmetic processing unit 412 is executed. When the write of the circuit data in the arithmetic processing unit 412 is completed, the arithmetic processing unit 412 notifies the processing switching unit 411 of the completion of the write, and the processing switching unit 411 changes the write necessity flag of the circuit data at the address A. The image capturing apparatus 110 reads out the device information at the address A after that, thereby knowing that the write of the analysis processing circuit data is completed.

Additionally, upon detecting that hardware configuration information in a predetermined format is not stored at the address A, the image capturing apparatus 110 determines that the device mounted in the mounting part does not have an image analysis processing function. Hence, after the determination, the image capturing apparatus 110 does not perform communication concerning the analysis processing function with the device. In this case, concerning data received from the image capturing apparatus 110, the detachable device 100 executes only the storage processing function of storing the data in the storage unit 404.

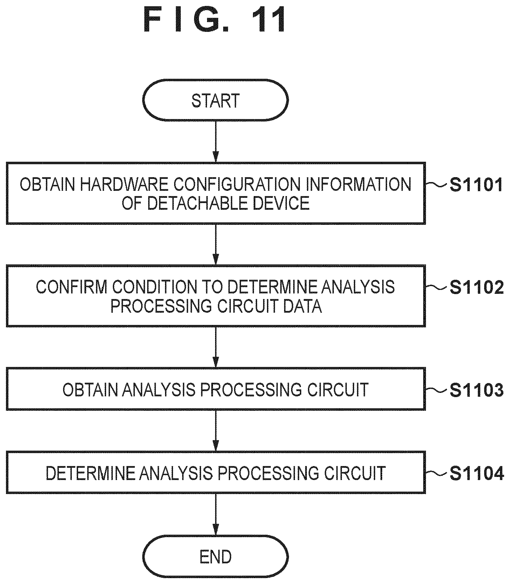

An example of the procedure of processing of the image capturing apparatus 110 to determine circuit data based on device information obtained from the detachable device 100 will be described next with reference to Fig. 11. This processing is executed in, for example, step S906 of Fig. 9. Upon detecting that the mounted device (detachable device 100) has the logic circuit reconfiguration function capable of configuring an analysis processing function, and write of analysis processing circuit data is necessary, the image capturing apparatus 110 requests device information from the detachable device 100. The image capturing apparatus 110 obtains hardware configuration information of the detachable device 100 from the obtained device information (step S1101). Next, the image capturing apparatus 110 confirms a condition to determine the analysis processing circuit data (step S1102). This condition is obtained based on, for example, the hardware arrangement of the detachable device 100, the arrangement of the image capturing apparatus 110, and an analysis processing function to be selected. The hardware arrangement of the detachable device 100 includes the model number of the FPGA, a connection PIN to a peripheral circuit, and the like. The arrangement of the image capturing apparatus 110 includes, for example, information of power that the image capturing apparatus 110 can supply to the detachable device 100, operation conditions of the image capturing apparatus such as information of temperature rise caused by an increase in the power consumption of the image capturing apparatus 110, and a communication rate. The arrangement of the image capturing apparatus 110 may include information concerning the image of a result of pre-analysis processing executed for a captured image. The information concerning the image of the result of pre-analysis processing can include at least one of the number of pixels, the cutting size, color difference/color space information such as RGB or YCbCr, the number of quantization bits such as 8 bits or 10 bits, and the image format of image data for which the image capturing apparatus causes the device to execute analysis processing. The arrangement of the image capturing apparatus 110 may be represented by a value capable of specifying information such as the model number of the image capturing apparatus 110. The analysis processing function is an analysis processing function selected by the image capturing apparatus 110.

The image capturing apparatus 110 transmits, for example, the confirmed condition to the management apparatus 140 together with the analysis processing circuit data request, and obtains analysis processing circuit data (step S1103). In this embodiment, the management apparatus 140 can hold analysis processing circuit data with a predetermined format as a database in the storage unit of the management apparatus 140. In this case, the management apparatus 140 selects analysis processing circuit data from the database based on the information received from the image capturing apparatus 110, and transmits the selected analysis processing circuit data to the image capturing apparatus 110. Every time the request from the image capturing apparatus 110 is received, the management apparatus 140 may perform logic synthesis based on information received together with the request, thereby generating analysis processing circuit data that matches the conditions of the image capturing apparatus 110 and the detachable device 100. The image capturing apparatus 110 determines analysis processing circuit data to be written in the detachable device 100 from the analysis processing circuit data obtained from the management apparatus 140 (step S1104). Note that in this embodiment, the management apparatus 140 holds or generates analysis processing circuit data. However, the image capturing apparatus 110 may have the function.

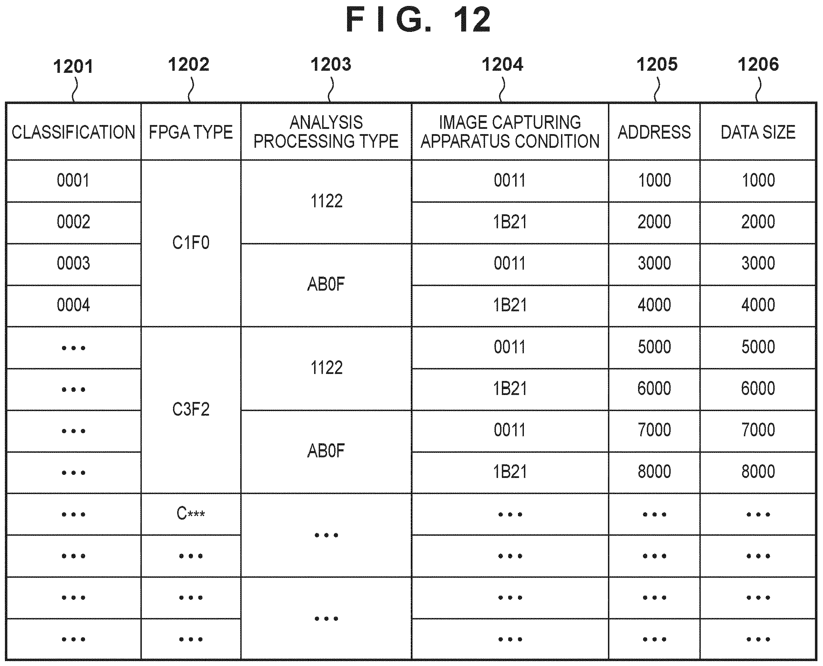

The structure of analysis processing circuit data in a case in which the management apparatus 140 holds the analysis processing circuit data will be described next with reference to Fig. 12. Fig. 12 shows an example of a table of analysis processing circuit data stored in the storage unit of the management apparatus 140. A classification 1201 indicates a serial number given to each analysis processing held by the management apparatus 140. An FPGA type 1202 represents information including the type and model number of an FPGA, constraint information including a connection PIN to a peripheral circuit, and the format of circuit data to be written. An analysis processing type 1203 represents information concerning the type of an analysis processing function such as crowd analysis, face detection, or audio pattern detection. An image capturing apparatus condition 1204 represents information corresponding to the configuration information of the image capturing apparatus. The image capturing apparatus condition 1204 also represents information concerning the power consumption of an FPGA, an input data size, and a format input specification. An address 1205 indicates an address at which each analysis processing circuit data is stored. A data size 1206 indicates the data size of analysis processing circuit data. Note that the items of the table are merely examples, and items may be added, or some items may be omitted in accordance with detailed conditions.

Based on information received in the request of analysis processing circuit data from the image capturing apparatus 110, the management apparatus 140 selects analysis processing circuit data corresponding to the information. For this reason, in an example, the database can be configured such that one analysis processing circuit data is determined based on obtained information. Since the management apparatus 140 transmits only one selected analysis processing circuit data to the image capturing apparatus 110, the amount of data communicated via the network can be suppressed. Note that if the image capturing apparatus 110 simultaneously presents a plurality of conditions, the management apparatus 140 may select a plurality of analysis processing circuit data corresponding to the plurality of conditions and transmit these to the image capturing apparatus 110. The image capturing apparatus 110 can store, in the storage unit 303, the plurality of analysis processing circuit data obtained from the management apparatus 140, and write appropriate analysis processing circuit data in the detachable device 100 in accordance with the operation mode of the image capturing apparatus 110. Analysis processing circuit data may be configured to include, in the circuit data, a set value used to execute analysis processing, or the set value may be prepared independently of the circuit data.

In addition, analysis processing circuit data and set values may be configured to implement different analysis processing functions by additionally setting different set values for one analysis processing circuit data. For this purpose, the management apparatus 140 may separately hold, in the database, set values used to change an analysis processing function corresponding to each analysis processing circuit data. In this case, the management apparatus 140 may transmit not only analysis processing circuit data but also set values corresponding to the analysis processing circuit data in response to the request of analysis processing circuit data from the image capturing apparatus 110.

In general, the storage capacity of the storage unit 303 of the image capturing apparatus 110 is limited. However, the image capturing apparatus 110 can obtain data from the management apparatus 140 for each necessary analysis processing in the above-described way, and overwrite the data on data in the region of the storage unit 303 where the analysis processing circuit data is stored. Hence, the image capturing apparatus 110 can cause the detachable device 100 to execute various kinds of analysis processing within the range of the data holding capability of the self-apparatus.

In the above-described method, analysis processing circuit data corresponding to the combination of the information of the detachable device 100, selected analysis processing, and the configuration information of the image capturing apparatus 110 is selected. For this reason, when the detachable device 100 having the same hardware configuration information is caused to execute the same analysis processing function, if the image capturing apparatus 110 in which the device is mounted changes, different analysis processing circuit data may be written. This can prevent an operation error of analysis processing in the detachable device 100, which occurs due to the difference in the functions of the image capturing apparatuses 110.

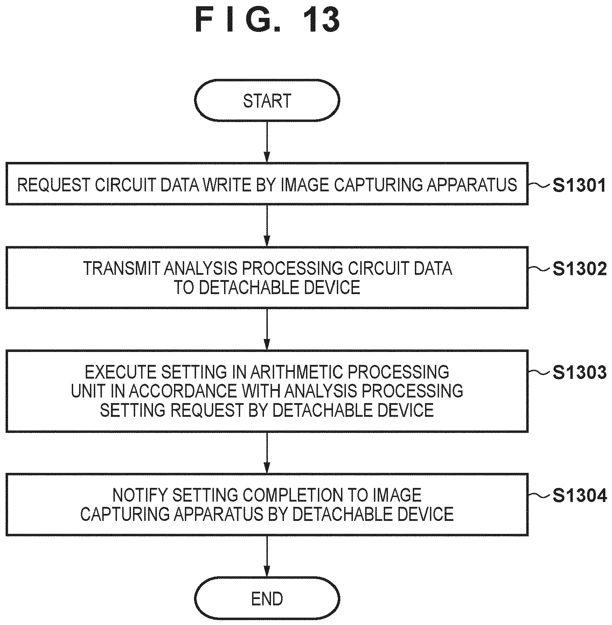

An example of analysis processing circuit data write processing in the detachable device 100 will be described next with reference to Fig. 13. First, the image capturing apparatus 110 transmits an analysis processing circuit data write request to the detachable device 100 (step S1301). The control unit 304 of the image capturing apparatus 110 controls the device communication unit 306 to issue a write request (write command) for a specific address to the mounted detachable device 100. The communication unit 502 of the detachable device 100 receives the circuit data write request from the image capturing apparatus 110. At this time, the communication unit 502 can discriminate the circuit data write request of execution target processing based on the data written from the image capturing apparatus 110 or the type of the write command. For example, the image capturing apparatus 110 writes the analysis processing circuit data at the address B of the detachable device (step S1302). The address B is a specific address of the storage unit 404 of the detachable device 100, where the analysis processing circuit data is stored. The information of the address B to store the analysis processing circuit data may be included in the device information, and the image capturing apparatus 110 can designate the address B stored in the device information and write the analysis processing circuit data.

Next, when the transmission of the analysis processing circuit data is completed, the image capturing apparatus 110 requests analysis processing setting. Upon receiving the analysis processing setting request, the detachable device 100 reads out the analysis processing circuit data placed at the address B, and writes the circuit data in the arithmetic processing unit 412. The processing switching unit 411 of the detachable device 100 reads out the analysis processing circuit data from the address B of the storage unit 404, and writes the readout analysis processing circuit data in the arithmetic processing unit 412. According to the request from the image capturing apparatus 110, the detachable device 100 sets set values for the analysis processing circuit deployed in the arithmetic processing unit 412 (step S1303).

When the write of the analysis processing circuit and the setting of the set values are completed, the detachable device 100 notifies the image capturing apparatus 110 of the setting completion (step S1304). The control unit 304 of the image capturing apparatus 110 controls the device communication unit 306 to receive the circuit data write completion notification from the detachable device 100. When the processing shown in Fig. 13 is executed in this way, the analysis processing function is prepared to be executable in the detachable device 100.

The notification of circuit data write completion (setting completion) from the detachable device 100 to the image capturing apparatus 110 can be executed using, for example, one of the following three methods. In the first notification method, the communication unit 502 outputs a BUSY signal in a case in which the setting of the execution target processing has not ended at the time of write processing of the data of the first block from the image capturing apparatus 110. Output of the BUSY signal is performed by, for example, driving a signal line of DATA defined by the SD standard to a Low state. In this case, the image capturing apparatus 110 confirms the BUSY signal, thereby discriminating whether the circuit data write in the arithmetic processing unit 412 is completed. In the second notification method, the time until circuit data write of the execution target processing is completed is stored in advance at the above-described specific address A, and the image capturing apparatus 110 reads out the information of the time until the circuit data write completion. After the elapse of the time until the completion of the write of circuit data of the execution target processing, the image capturing apparatus 110 outputs write data (issues a write command). This allows the image capturing apparatus 110 to transmit the data of the captured image after the circuit data write is completed. In the third notification method, when the circuit data write is completed, the analysis unit 501 writes a setting completion flag at a second specific address of the detachable device 100. The image capturing apparatus 110 reads out the data at the second specific address, thereby discriminating whether the circuit data write is completed. Note that the information of the address at which the circuit data write completion flag is written may be stored at the above-described specific address or may be stored at another address.

In addition, processing of writing the analysis processing circuit data in the arithmetic processing unit 412 may automatically be executed by detecting the flag information at the address A by the processing switching unit 411. For example, upon detecting the completion of the write of the analysis processing circuit data at the address B of the storage unit 404, the input/output control unit 410 of the detachable device 100 sets " 1 " as the value of the circuit data holding flag 1003 at the address A. When the value of the circuit data holding flag 1003 becomes "1", the processing switching unit 411 reads out the analysis processing circuit data from the address B of the storage unit 404, and writes the readout analysis processing circuit data in the arithmetic processing unit 412. When reconfiguration of the logic circuit is completed, the arithmetic processing unit 412 notifies the input/output control unit 410 of the completion of the reconfiguration of the logic circuit. In accordance with the notification, the input/output control unit 410 sets "1" as the value of the circuit data write completion flag at the address A. The image capturing apparatus 110 can read out the value of the circuit data write completion flag at the address A, and if the value is "1", confirm that the analysis processing function can be executed.

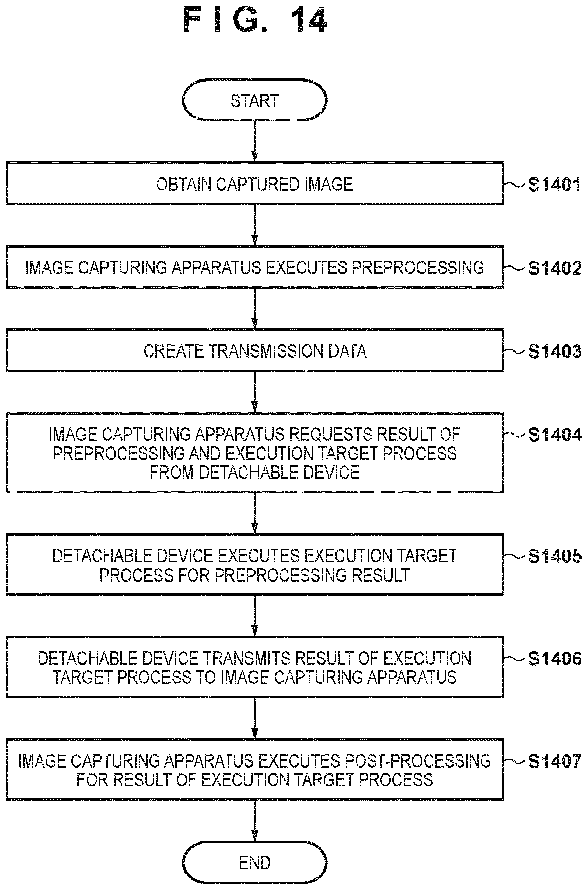

An example of the procedure of processing performed when the image capturing apparatus 110 causes the detachable device 100 to execute analysis processing will be described next with reference to Fig. 14. In this processing, first, the image capturing control unit 301 captures the peripheral environment (step S1401). The control unit 304 controls the signal processing unit 302 to process an image captured by the image capturing control unit 301 and obtain a captured image. After that, the control unit 304 controls the analysis unit 305 to execute pre-analysis processing for the captured image input from the control unit 304 and obtain the image of the pre-analysis processing result (step S1402). After determining whether the execution target processing is included in the executable analysis processing list, the control unit 304 generates transmission data including the image of the pre-analysis processing result (step S1403). The control unit 304 controls the device communication unit 306 to transmit the data to the detachable device 100 (step S1404). For example, the control unit 304 issues a write request (write command) of the pre-analysis processing result, thereby transmitting the image of the pre-analysis processing result to the detachable device 100. The communication unit 502 of the detachable device 100 receives the image of the pre-analysis processing result from the image capturing apparatus 110, and outputs the image received from the image capturing apparatus 110 to the analysis unit 501. The analysis unit 501 executes the set execution target processing for the image input from the communication unit 502 (step S1405). Then, the communication unit 502 transmits the analysis processing result obtained by the processing of the analysis unit 501 to the image capturing apparatus 110 (step S 1406). The control unit 304 of the image capturing apparatus 110 controls the device communication unit 306 to receive the analysis processing result from the detachable device 100. After that, the control unit 304 controls the analysis unit 305 to execute post-analysis processing for the analysis processing result (step S1407). The post-analysis processing is, for example, processing such as analysis result storage processing or display.

Transmission of the analysis processing result from the detachable device 100 to the image capturing apparatus 110 is done, for example, in the following way. The analysis unit 501 of the detachable device 100 stores the analysis processing result at the storage destination address for the analysis processing result, which is assigned for each execution target processing. The image capturing apparatus 110 reads out information representing the storage address of the analysis processing result, which is stored at the address A together with, for example, the second processing list, and issues a read request (read command) for the storage address. The detachable device 100 receives the read request for the storage address of the analysis processing result via the communication unit 502, and outputs the analysis processing result to the image capturing apparatus 110. Note that the image capturing apparatus 110 can issue the read request for the storage address of the analysis processing result, for example, after the elapse of an estimated processing time stored at the address A. In addition, the detachable device 100 may output a BUSY signal from the write request of the last block of the pre-analysis processing result transmitted from the image capturing apparatus 110 to the end of the execution target processing. In this case, the image capturing apparatus 110 can issue the read request for the storage address of the analysis processing result when the BUSY signal is not received any more. This allows the image capturing apparatus 110 to obtain the processing result after the end of the processing.

In the above-described embodiment, the method of storing information concerning a processing function at the specific address A of the storage unit 404 of the detachable device 100 has been described. However, the present invention is not limited to this. For example, the information of a processing function may be added to the response argument part of a response to a command used at the time of initialization of the detachable device 100.

Communication between the image capturing apparatus 110 and the detachable device 100 will be described next. The arithmetic processing unit 203 of the image capturing apparatus 110 and the SD controller 403 of the detachable device 100 are connected by a power supply line, a GND line, a clock line, a command line, and a data line via the device insertion socket of the SD I/F unit 205 of the image capturing apparatus 110. Note that the clock line, the command line, and the data line are connected via the FPGA 402. On the clock line, a synchronization clock (CLK) output from the arithmetic processing unit 203 is communicated. On the command line, a command issued for an operation request from the arithmetic processing unit 203 to the SD controller 403 and a response to the command from the SD controller 403 to the arithmetic processing unit 203 are communicated. On the data line, write data from the arithmetic processing unit 203 and read data from the detachable device 100 are communicated. In addition, the arithmetic processing unit 203 discriminates High and Low of a device detect signal of the device insertion socket of the SD I/F unit 205, thereby recognizing whether the detachable device 100 is inserted.

The arithmetic processing unit 203 issues a command to the SD controller 403 on the command line after power supply. Upon receiving a response from the SD controller 403 and output data representing device information as an SD card, the arithmetic processing unit 203 sets a voltage for data communication, a communication speed (clock frequency), and the like.

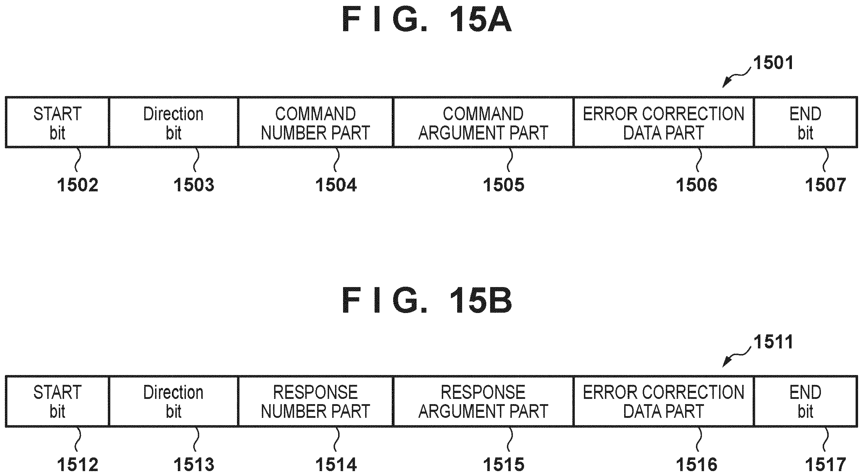

Figs. 15A and 15B show examples of the structures of a command and a response communicated on the command line. The command and response have structures complying with the SD standard. A command 1501 issued from the arithmetic processing unit 203 to the SD controller 403 is configured to include a command number part 1504, a command argument part 1505, and an error correction data part 1506. In the command number part 1504, a value indicating the type of the command is described. For example, if a value "23" is stored in the command number part 1504, this indicates that the command is a block count designation command for designating the number of data blocks. If a value "25" is stored in the command number part 1504, this indicates that the command is a multi-write command. If a value "12" is stored in the command number part 1504, this indicates that the command is a data transfer stop command. In the command argument part 1505, pieces of information such as the number of transfer data blocks and the write/read address of a memory are designated in accordance with the type of the command. A command start bit 1502 representing the start position of the command is added to the first bit of the command, and a command end bit 1507 representing the end of the command is added to the final bit of the command. Additionally, a direction bit 1503 representing that the command is a signal output from the image capturing apparatus 110 to the detachable device 100 is also added after the command start bit 1502.

A response 1511 returned from the SD controller 403 in response to the command from the arithmetic processing unit 203 includes a response number part 1514 representing for which command the response is returned, a response argument part 1515, and an error correction data part 1516. A response start bit 1512 representing the start position of the response is added to the first bit of the response, and a response end bit 1517 representing the end position of the response is added to the final bit of the response. Additionally, a direction bit 1513 representing that the response is a signal output from the detachable device 100 to the image capturing apparatus 110 is also added after the response start bit 1512. In the response argument part 1515, pieces of information such as the status of the SD card are stored in accordance with the command type.

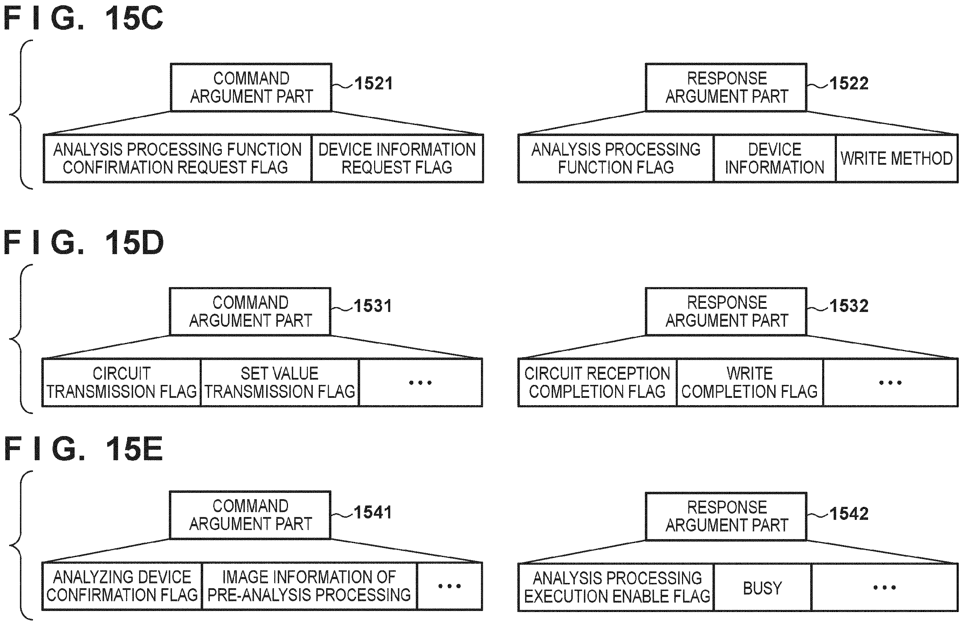

Examples of a command and a response associated with this embodiment will be described next with reference to Figs. 15C to 15E. In this embodiment, for example, a device confirmation command, an analysis processing setting command, and an analysis processing request command are used. The device confirmation command is a command that is transmitted from the image capturing apparatus 110 to the detachable device 100 when confirming whether the detachable device 100 has a logic circuit reconfiguration function capable of configuring an analysis processing function. The analysis processing setting command is a command used to write analysis processing circuit data and set values thereof from the image capturing apparatus 110 to the detachable device 100. The analysis processing request command is a command used to request execution of analysis processing from the image capturing apparatus 110 to the detachable device 100. Fig. 15C shows examples of a command argument part and a response argument part in the device confirmation command. Similarly, Figs. 15D and 15E show examples of command argument parts and response argument parts in the analysis processing setting command and the analysis processing request command, respectively. Note that an example in which various kinds of inquiries are made by setting the contents of the command argument part and the response argument part will be described here. However, a dedicated command number used to make an inquiry to the detachable device 100 may be prepared.

A command argument part 1521 of the device confirmation command can be configured to include an analysis processing function confirmation request flag for confirming whether the device of the inquiry destination is an analysis processing device, and a device information request flag. A command argument part 1531 of the analysis processing setting command can be configured to include a circuit transmission flag for notifying transmission of analysis processing circuit data, and a set value transmission flag for notifying transmission of the set values of the analysis processing. A command argument part 1541 of the analysis processing request command can be configured to include an analysis processing request flag for requesting execution of analysis processing, and image information of pre-analysis processing. The image information of pre-analysis processing includes, for example, argument values representing an image size, an image format (RGB or YUV), and a resolution (8 bits or 10 bits).

A response argument part 1522 of a response to the device confirmation command can include an analysis processing function flag representing whether the device has a logic circuit reconfiguration function capable of configuring an analysis processing function, an argument value representing device information, and an argument value representing a circuit data write method. For example, the image capturing apparatus 110 confirms that the value of the analysis processing device flag is set to "1", thereby recognizing that the detachable device 100 has the logic circuit reconfiguration function. A response argument part 1532 of a response to the analysis processing setting command can include a circuit reception completion flag for notifying completion of reception of analysis processing circuit data, and a circuit write completion flag for notifying that the write of circuit data in the arithmetic processing unit is completed. A response argument part 1542 of a request to the analysis processing request command can be configured to include an analysis processing execution enable flag representing that analysis processing can be executed, and an argument value representing a BUSY state.

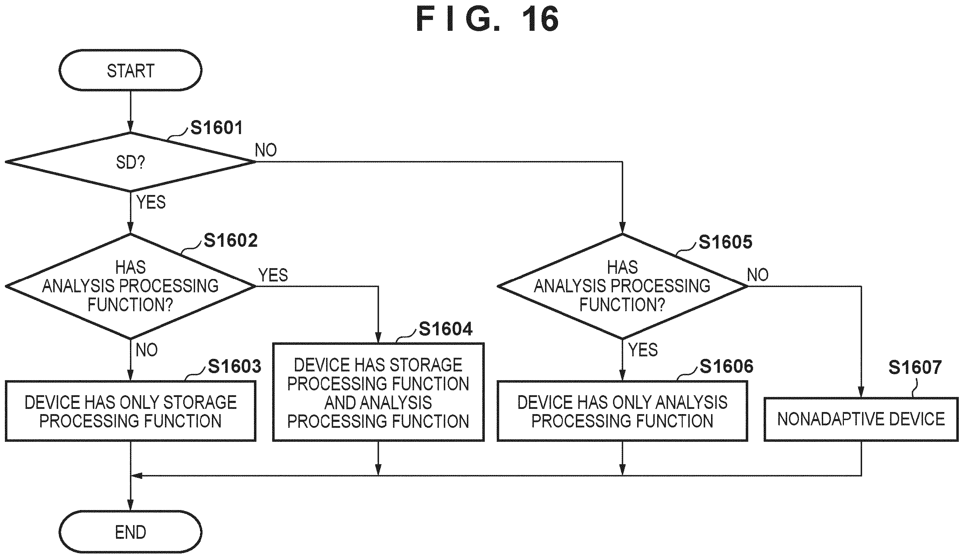

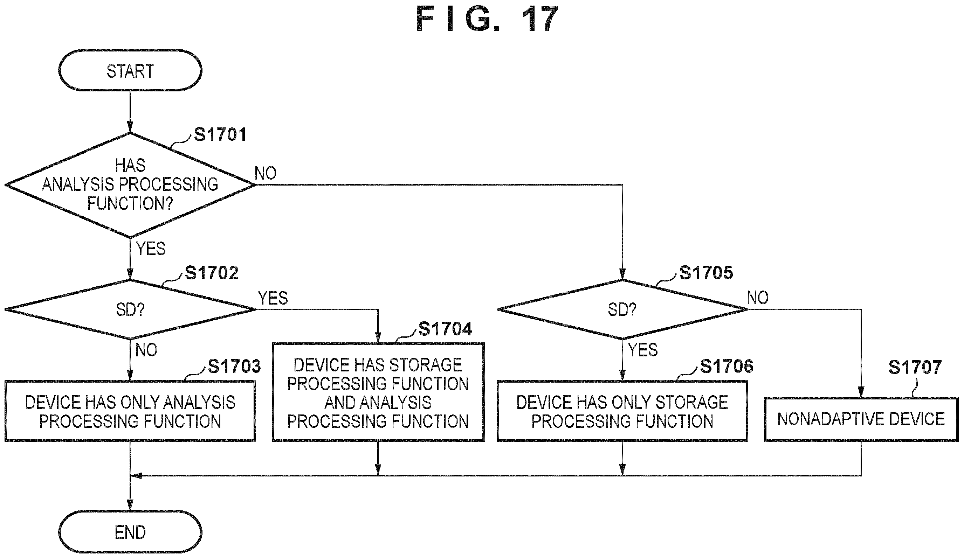

Processing of the image capturing apparatus 110 to determine whether the detachable device 100 has a logic circuit reconfiguration function capable of configuring an analysis processing function and determine the classification of the detachable device 100 will be described next with reference to Figs. 16 and 17. Fig. 16 shows an example of the procedure of processing of determining whether the mounted detachable device 100 operates as an SD card and then determining whether the detachable device 100 has the logic circuit reconfiguration function capable of configuring an analysis processing function. Fig. 17 shows an example of the procedure of processing of determining whether the detachable device 100 has the logic circuit reconfiguration function capable of configuring an analysis processing function and then determining whether the mounted detachable device 100 operates as an SD card. In these processes, only the determination order is different, and the processing result to be obtained is the same. The image capturing apparatus 110 determines whether the detachable device 100 (1) has only the storage processing function, (2) has the storage processing function and the analysis processing function, (3) has only the analysis processing function, or (4) has neither the storage processing function nor the analysis processing function. Note that in this embodiment, when using functions as a general SD card, the image capturing apparatus 110 performs communication with the device mounted in the SD card slot using commands complying with the SD standard. On the other hand, when using the analysis processing function, the image capturing apparatus 110 performs communication using commands that are not defined by the SD standard. That is, communication is performed using the interface of SD in both the storage processing function and the analysis processing function. As the commands in the communication, commands defined by the SD standard and commands other than those can be used. Note that the commands that are not defined by the SD standard include, for example, existing commands in which some arguments are set to impossible values in the existing SD standard. That is, for some commands, commands complying with the SD standard used in a conventional SD card having a storage processing function may be used by changing arguments. Also, "a command that does not comply with the SD standard" in this embodiment means a command that is not defined by the SD standard at the present time. That is, if a command that does not comply with the SD standard for causing the device to execute processing described in this embodiment is defined as a new command in the SD standard, this command may be regarded as "a command newly defined by the SD standard".

If it is determined that the detachable device "(1) has only the storage processing function", the detachable device functions as a normal SD card and performs communication using commands complying with the SD standard.

If it is determined that the detachable device "(2) has only the storage processing function and the analysis processing function", the detachable device determines whether an input command is a command complying with the SD standard or a command other than that. The detachable device transmits information to the SD controller and executes the storage processing function, or transmits information to the arithmetic processing unit and the processing switching unit and executes the analysis processing function. The storage processing function and the analysis processing function may be executed in parallel for the same received data. That is, the received data may directly be stored, and analysis processing for the data may simultaneously be executed. At this time, processes by these functions may be executed simultaneously, or may be executed at different timings. An analysis result obtained by the arithmetic processing unit may be held in the storage unit. A status concerning the analysis processing may be output from the arithmetic processing unit to the storage unit and held in the storage unit. In the above-described embodiment, an example in which analysis processing circuit data and set values thereof are at least temporarily accumulated in the storage unit and deployed in the arithmetic processing unit in accordance with the end of accumulation has been described. However, the present invention is not limited to this. For example, after the analysis processing circuit data and set values thereof are held in the storage unit, these need not be deployed in the arithmetic processing unit until activation of the analysis processing function. In this case, the analysis processing circuit data may be read out from the storage unit and deployed in the arithmetic processing unit in accordance with activation of the analysis processing function. Note that as for communication between the arithmetic processing unit and the storage unit, the arithmetic processing unit and the storage unit may directly be connected, and direct communication may be performed between them.

If it is determined that the detachable device "(3) has only the analysis processing function", the detachable device operates by, for example, commands that are not defined by the SD standard. Based on a command that does not comply with the SD standard, the detachable device transmits data corresponding to the command to at least one of the arithmetic processing unit and the processing switching unit, and executes the analysis processing function. The detachable device may be configured not to include an analysis processing circuit configured to activate the analysis processing function or a nonvolatile storage function capable of storing the set values. In this case, upon detecting mounting of the detachable device, the image capturing apparatus 110 transmits the analysis processing circuit and set values thereof to the detachable device. The detachable device sets the arithmetic processing unit based on the received information such that the analysis processing function becomes usable. In such a detachable device, analysis processing function activation processing is performed at every time of insertion/removal or power supply reactivation. The arrangement of such a device will be described later.

If it is determined that the detachable device "(4) has neither the storage processing function nor the analysis processing function", the detachable device is handled as a nonadaptive device for the image capturing apparatus 110. In this case, for example, the image capturing apparatus 110 transmits the determination result to the input/output apparatus 130, thereby notifying the user that the mounted device is a nonadaptive device. The image capturing apparatus 110 can be configured to recognize a configuration processible in the detachable device by obtaining the device information of the detachable device.

Processing shown in Fig. 16 will be described. In this processing, first, based on detection of insertion of a device to the mounting part of the self-apparatus, the image capturing apparatus 110 supplies power and CLK to the device via the SD I/F unit 205. Next, for the mounted device, the image capturing apparatus 110 executes initialization processing as an SD card, and determines whether the device is an SD card (step S1601). The image capturing apparatus 110 determines, based on, for example, completion of the initialization processing, that the mounted device is an SD card (YES in step S1601). On the other hand, for example, if the initialization processing fails, the image capturing apparatus 110 determines that the mounted device is not an SD card (NO in step S1601). Note that the image capturing apparatus 110 can determine that the initialization processing has failed if, for example, a command is transmitted to the mounted device, but no response is received within a predetermined time, or a response representing that the device is not an SD card is received.

Upon determining that the mounted device is an SD card (YES in step 51601), the image capturing apparatus 110 transmits a device confirmation command to the mounted device. The control unit 304 of the image capturing apparatus 110 receives a device confirmation response to the command, and determines whether the device has the logic circuit reconfiguration function capable of configuring an analysis processing function (step S1602). In addition, the image capturing apparatus 110 obtains the device information of the device. The image capturing apparatus 110 can obtain the device information as the argument value of the response to the command. However, the image capturing apparatus 110 may transmit a read command for requesting data read to the device and obtain device information from the data line. Upon determining that the mounted device has the logic circuit reconfiguration function (YES in step S1602), the image capturing apparatus 110 recognizes that the device is a device having the storage processing function and the analysis processing function and ends the processing (step S1604). On the other hand, upon determining that the mounted device does not have the logic circuit reconfiguration function (NO in step S 1602), the image capturing apparatus 110 determines that the currently mounted device is a device having only the storage processing function (step S 1603). Note that the image capturing apparatus 110 can determine that the device does not have the logic circuit reconfiguration function if the response to the device confirmation command is not received within a predetermined time. Even in a case in which a response representing a status error is received, or a response that does not include an expected argument value is received, the image capturing apparatus 110 can determine that the device does not have the logic circuit reconfiguration function.

Upon determining that the mounted device is not an SD card (NO in step S1601), the image capturing apparatus 110 transmits a device confirmation command of analysis processing and determines whether the device has the analysis processing function (step S1605). Upon receiving a device confirmation response, the image capturing apparatus 110 determines that the mounted device has the analysis processing function but does not have the storage processing function (YES in step S1605, and step S1606). On the other hand, if a device confirmation response cannot be received, the image capturing apparatus 110 determines that the mounted device is a nonadaptive device that has neither the analysis processing function nor the storage processing function (NO in step S1605, and step S1607).

Processing shown in Fig. 17 will be described. In this processing as well, first, based on detection of insertion of a device to the mounting part of the self-apparatus, the image capturing apparatus 110 supplies power and CLK to the device via the SD I/F unit 205. Next, the image capturing apparatus 110 transmits a device confirmation command to the mounted device, and determines whether the device has the logic circuit reconfiguration function capable of configuring an analysis processing function (step S1701). For example, the image capturing apparatus 110 can receive a response to the device confirmation command and determine, based on the contents of the received response, whether the mounted device has the logic circuit reconfiguration function. Note that the image capturing apparatus 110 can determine that the device does not have the logic circuit reconfiguration function if the response to the device confirmation command is not received within a predetermined time. Even in a case in which a response representing a status error is received, or a response that does not include an expected argument value is received, the image capturing apparatus 110 can determine that the device does not have the logic circuit reconfiguration function. Note that it may be determined whether the mounted device has the logic circuit reconfiguration function by a method different from the method using the device confirmation command.

Upon determining that the mounted device has the logic circuit reconfiguration function (YES in step S1701), the image capturing apparatus 110 subsequently obtains device information from the device. Then, the image capturing apparatus 110 determines analysis processing circuit data according to the obtained device information, and writes the circuit data in the mounted device. After that, upon detecting, for example, a notification of completion of the circuit data write in the device, the image capturing apparatus 110 executes initialization processing as an SD card, and determines whether the device is an SD card (step S1702). The image capturing apparatus 110 determines, based on, for example, completion of the initialization processing, that the mounted device is an SD card (YES in step S1702). On the other hand, for example, if the initialization processing fails, the image capturing apparatus 110 determines that the mounted device is not an SD card (NO in step S1702). Note that the image capturing apparatus 110 can determine that the initialization processing has failed if, for example, a command is transmitted to the mounted device, but no response is received within a predetermined time, or a response representing that the device is not an SD card is received. Upon determining that the mounted device is an SD card (YES in step S1702), the image capturing apparatus 110 determines that the device is a device having the analysis processing function and the storage processing function (step S1704). Note that when the mounted device executes communication with the image capturing apparatus 110 and performs setting in steps S1701 and S1702, preparation for use of the analysis processing function is completed. On the other hand, upon determining that the mounted device is not an SD card (NO in step S1702), the image capturing apparatus 110 determines that the device is a device having only the analysis processing function (step S1703).

Even in a case in which it is determined that the mounted device does not have the logic circuit reconfiguration function (NO in step S1701) as well, the image capturing apparatus 110 executes initialization processing as an SD card, and determines whether the device is an SD card (step S1705). Upon determining that the mounted device is an SD card (YES in step S1705), the image capturing apparatus 110 determines that the device is a device having only the storage processing function (step S1706). On the other hand, upon determining that the mounted device is not an SD card (NO in step S1705), the image capturing apparatus 110 determines that the device is a nonadaptive device that has neither the analysis processing function nor the storage processing function (step S1707). In the processing shown in Fig. 17, the device confirmation command is transmitted immediately after the supply of power and CLK to the device. This shortens the time until it is determined whether the device has the logic circuit reconfiguration function. In this case, for example, the initialization processing as an SD card and the processing of the image capturing apparatus 110 to access the management apparatus 140 and obtain circuit data and the like can be executed in parallel, and the time until the start of processing in the device can also be shortened.

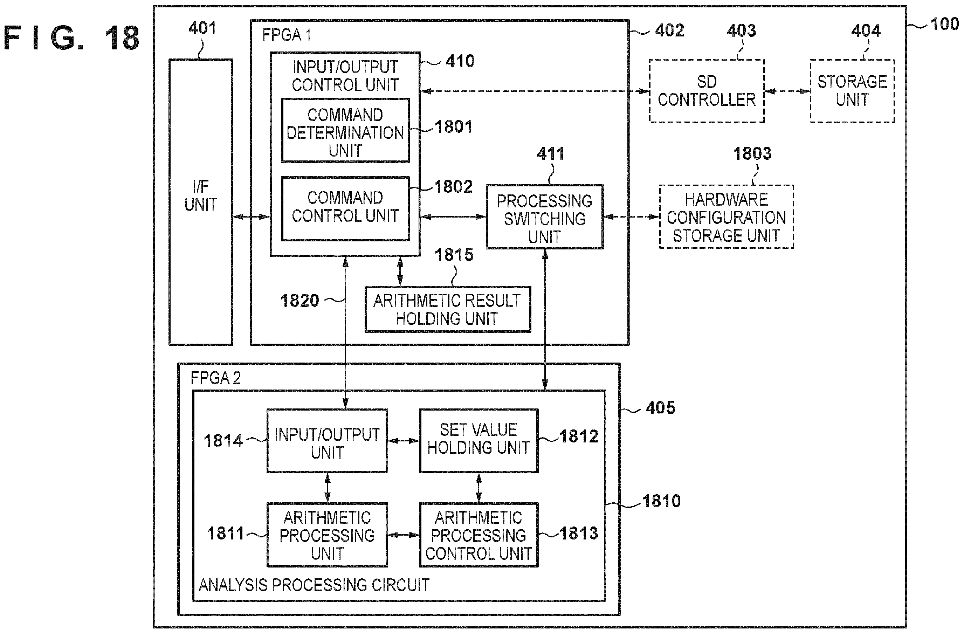

Fig. 18 shows an example of the arrangement of the detachable device 100 in a case in which it does not have a nonvolatile storage function for holding analysis processing circuit data. At every time of mounting in the image capturing apparatus 110 and reception of power supply, the detachable device 100 receives analysis processing circuit data from the image capturing apparatus 110, and configures an analysis processing circuit in the FPGA 405. Note that in the following description, a description of the same components as in Fig. 4 will be omitted.

In the arrangement shown in Fig. 18, the input/output control unit 410 of the detachable device 100 includes, for example, a command determination unit 1801 and a command control unit 1802. The command determination unit 1801 detects a dedicated command concerning analysis processing. The command control unit 1802 generates a response to be returned to the image capturing apparatus 110. Upon detecting a dedicated command concerning analysis processing, the command determination unit 1801 of the input/output control unit 410 does not transfer the command to the SD controller 403, and transmits an instruction only to the processing switching unit 411. The command control unit 1802 can freely generate a response to a command.

A hardware configuration information storage unit 1803 stores the hardware configuration information of the detachable device 100. The hardware configuration information storage unit 1803 is configured to store, for example, a part of information stored at the address A shown in Fig. 10. The information held as the hardware configuration information can be, for example, identification information capable of discriminating the arrangement (the model number and constraint information) of the FPGA405 of the detachable device 100. If identification information capable of specifying these pieces of information is used in place of information representing the arrangement of the FPGA405 itself, the amount of information that should be held can be suppressed.

When analysis processing circuit data is received from the image capturing apparatus 110, the command determination unit 1801 detects the data and transfers it to the processing switching unit 411. The processing switching unit 411 writes the received analysis processing circuit data in the FPGA 405. An analysis processing circuit is thus reconfigured in the FPGA 405. An analysis processing circuit 1810 represents the arrangement of the reconfigured analysis processing circuit. The analysis processing circuit 1810 can be configured to include processing circuits corresponding to an arithmetic processing unit 1811, a set value holding unit 1812, an arithmetic processing control unit 1813, and an input/output unit 1814. That is, in an example, the analysis processing circuit data provided from the image capturing apparatus 110 is generated as logic circuit data including these processing circuits. The arithmetic processing unit 1811 is an arithmetic circuit formed by a combination of a plurality of arithmetic processing circuits. The arithmetic processing unit 1811 may be configured to include a storage holding circuit that stores an intermediate processing result generated when processing is sequentially performed in the plurality of arithmetic processes included in it. The set value holding unit 1812 is a storage circuit that holds the set values of analysis processing received from the image capturing apparatus 110. The set values of analysis processing can include set values set for the arithmetic processing circuits of the arithmetic processing unit 1811, and set values used to control the order and the count of operations in the arithmetic processing circuits. The arithmetic processing control unit 1813 is a control circuit that sets the set values set in the set value holding unit 1812 to the arithmetic processing unit 1811, and controls the operation of the arithmetic processing unit 1811 in accordance with a sequence set value held in the set value holding unit 1812. The input/output unit 1814 is a communication circuit that performs transmission/reception to/from the input/output control unit 410. The set values of analysis processing from the input/output control unit 410 are transmitted to the input/output unit 1814 via a data bus 1820, and the input/output unit 1814 transfers the received set values of analysis processing to the set value holding unit 1812. In addition, an image before analysis processing, which is received from the image capturing apparatus 110, is input to the arithmetic processing unit 1811 via the input/output unit 1814, and an analysis result after execution of analysis processing by the arithmetic processing unit 1811 is transferred to the input/output control unit 410 via the input/output unit 1814. Note that the analysis result after execution of analysis processing by the arithmetic processing unit 1811 is transferred to an arithmetic result holding unit 1815 via the input/output control unit 410. The arithmetic result holding unit 1815 is a storage circuit that holds an analysis result after execution of analysis processing for an image or audio data in the arithmetic processing unit 1811. The arithmetic result holding unit 1815 may be configured in the FPGA 402 or in the FPGA 405. If the arithmetic result holding unit 1815 is configured in the FPGA 405, the input/output unit 1814 can be configured to read out an arithmetic processing result held by the arithmetic result holding unit 1815 in accordance with a request from the input/output control unit 410.

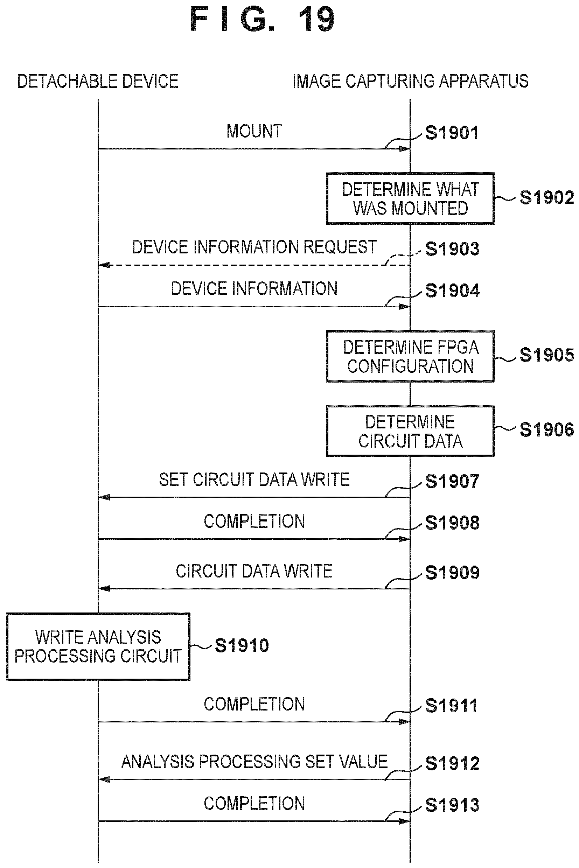

An example of the procedure of processing after the detachable device 100 is mounted until the detachable device 100 is caused to activate the analysis processing function will be described next with reference to Fig. 19.

In this processing, first, the detachable device 100 is mounted in the image capturing apparatus 110 (step S1901). The image capturing apparatus 110 determines whether the mounted device is a device having the logic circuit reconfiguration function capable of configuring an analysis processing function (step S1902). Note that it is assumed here that the image capturing apparatus 110 determines that the detachable device 100 has the logic circuit reconfiguration function. Then, the image capturing apparatus 110 transmits a signal for requesting device information to the detachable device (step S1903). The request signal is transmitted in, for example, a form of a command as shown in Figs. 15A and 15C. In response to the request signal, the detachable device 100 transmits device information to the image capturing apparatus 110 (step S1904). The device information is transmitted by, for example, a response as shown in Figs. 15B and 15C.

Upon receiving the device information of the detachable device 100, the image capturing apparatus 110 obtains the hardware configuration information of the detachable device 100 from the device information, and determines the FPGA configuration in the detachable device 100 (step S1905). The image capturing apparatus 110 determines the write data of the analysis processing circuit based on the FPGA configuration (step S1906). After that, the image capturing apparatus 110 requests the detachable device 100 to write the determined analysis processing circuit data (step S1907). The detachable device 100 makes a preparation for the write of the analysis processing circuit data, and transmits a completion notification to the image capturing apparatus 110 (step S1908). Based on reception of the completion notification, the image capturing apparatus 110 transmits the analysis processing circuit data to the detachable device 100 (step S1909). Upon receiving the analysis processing circuit data, the detachable device 100 writes the analysis processing circuit data in the FPGA 405, and starts an arithmetic processing circuit (step S1910). When the write of the analysis processing circuit data is completed, the detachable device 100 transmits a completion notification to the image capturing apparatus 110 (step S1911). Upon detecting the completion of the write of the analysis processing circuit data, the image capturing apparatus 110 transmits the set values of analysis processing to the detachable device 100 (S1912). The write of the set values is done using, for example, a write command of the SD standard. The detachable device 100 sets the set value of analysis processing in the FPGA 405, activates the analysis processing function, and notifies the image capturing apparatus 110 of activation completion (step S1913). The analysis processing function of the detachable device 100 can be activated in the above-described way.

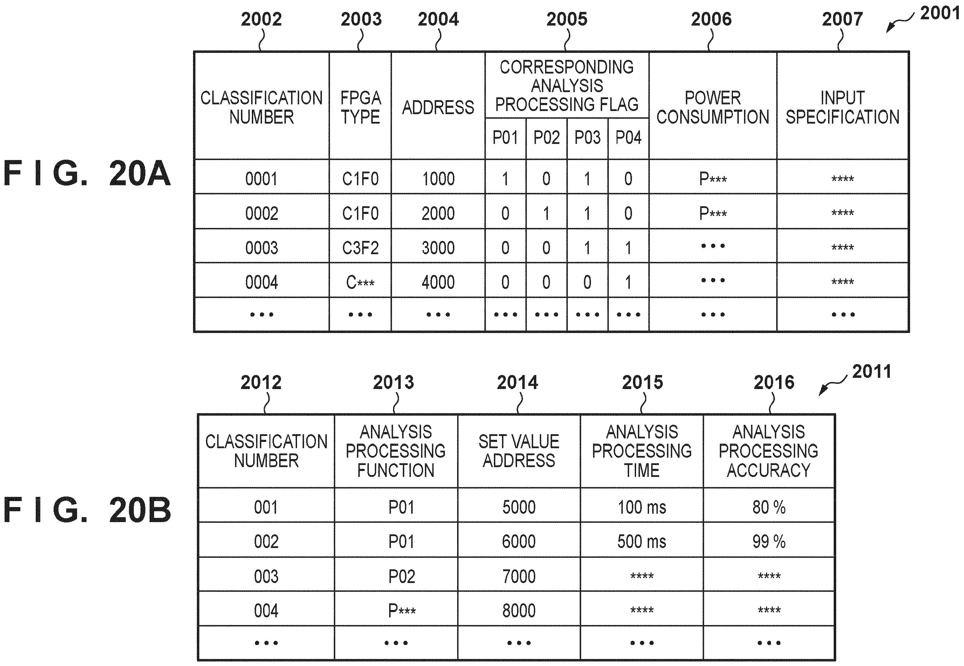

In an example, the image capturing apparatus 110 can store information concerning each of the analysis processing circuit data and the set values of analysis processing in the storage unit 303. Hence, the image capturing apparatus 110 can select the analysis processing circuit data to be transmitted to the detachable device 100 in accordance with the type of the FPGA of the detachable device 100 without, for example, performing communication with the management apparatus 140. An example of information stored in this case will be described with reference to Figs. 20A and 20B.

A table 2001 is an example of a table of analysis processing circuit data. A circuit data classification 2002 is an index added to analysis processing circuit data stored in the image capturing apparatus. An FPGA type 2003 indicates the type of an FPGA to which analysis processing circuit data corresponds. An address 2004 represents a position where the analysis processing circuit data is stored in the storage unit 303. A corresponding analysis processing flag 2005 represents which analysis processing function each analysis processing circuit data corresponds to. The image capturing apparatus 110 confirms the corresponding analysis processing flag, thereby discriminating an analysis processing function executable for each FPGA type. Power consumption 2006 represents power consumption according to the analysis processing function of the detachable device 100 when processing corresponding to analysis processing circuit data is executed. An input specification 2007 represents an input specification for a processing function corresponding to analysis processing circuit data. For example, values indicating the input size of an image, the resolution of an image (8 bits/10 bits/16 bits), a format (RGB/YUV), and the like are stored as the input specification 2007. Note that Fig. 20A shows an example in which analysis processing circuit data is held for each FPGA type. However, the present invention is not limited to this. That is, analysis processing circuit data may be selected by combining conditions other than those shown here.

A table 2011 is an example of a table of set values of analysis processing. The set values of analysis processing are set values representing, for example, the order and the type of each operation processed in the arithmetic processing unit 412, coefficients of each operation, and the like. A classification 2012 is an index added to a set value stored in the image capturing apparatus. An analysis processing function 2013 represents an analysis processing function to which each set value corresponds. An address 2014 represents a position where the set value is stored in the storage unit 303. An analysis processing time 2015 represents the reference value of time needed for analysis processing. Note that since the analysis processing time changes depending on the driving frequency of the arithmetic processing unit 412 of the detachable device 100 to drive analysis processing, an assumed analysis processing time can be calculated by calculation based on the value of the analysis processing time 2015 and the driving frequency. An analysis processing accuracy 2016 is a reference value of analysis accuracy when an analysis processing function is executed. The set values of analysis processing are configured to include set values set in the arithmetic processing circuits of the arithmetic processing unit 1811 and set values used to control the order and count of performing operations in the arithmetic processing circuits. Since the order and count of performing operations in an arithmetic processing circuit change for each analysis processing, the analysis processing time changes for each analysis processing. Additionally, in analysis processing that needs hierarchical repetitive operations, the accuracy of analysis processing increases as the hierarchical structure becomes large. On the other hand, the analysis time tends to be long.

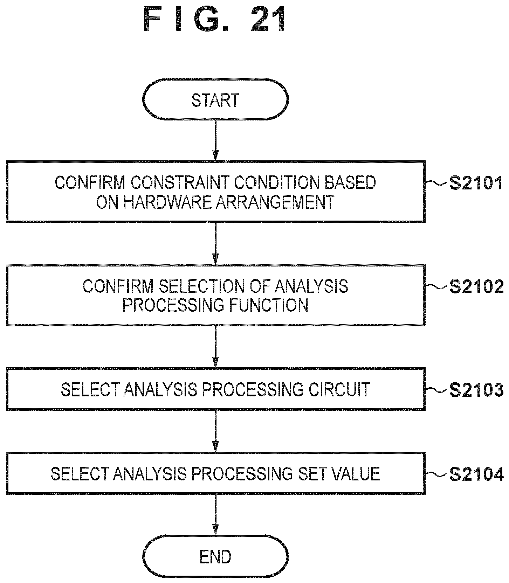

An example of the procedure of processing of the image capturing apparatus 110 to select analysis processing circuit data and set values of analysis processing will be described next. Connection to the management apparatus 140 may be impossible depending on the installation situation of the image capturing apparatus 110. Even if the image capturing apparatus 110 can communicate with the management apparatus 140, activation of the analysis processing function may be delayed due to the influence of the line speed. Hence, an example of the procedure of processing of activating the analysis processing function of the detachable device 100 using analysis processing circuit data and the set values of analysis processing, which are held in the image capturing apparatus 110, will be described here. Fig. 21 shows an example of the procedure of this processing.

In this processing, first, the image capturing apparatus 110 obtains device information, and confirms constraints by the hardware arrangement of the detachable device 100 (step S2101). In addition, the image capturing apparatus 110 can confirm the constraint conditions of the self-apparatus. The constraint conditions of the image capturing apparatus 110 are associated with, for example, an image size and an image format when performing preprocessing of a current captured image. If processing to be executed is audio processing, the constraint conditions of the image capturing apparatus 110 can be the compression format, the bit rate, and the like of recorded audio data. Next, the image capturing apparatus 110 confirms an analysis processing function selected by the user via, for example, the input/output apparatus 130 (step S2102). Note that if user selection is not done, it may be handled as a predetermined analysis processing function is selected.

After that, the image capturing apparatus 110 selects analysis processing circuit data according to the analysis processing function (step S2103). The image capturing apparatus 110 selects set values settable in an analysis processing circuit corresponding to the selected analysis processing function (step S2104). For example, in Fig. 20A, FPGA "C1F0" and FPGA "C3F2" indicate different FPGAs. For this reason, upon detecting that the FPGA of the detachable device 100 is "ClF0" from the obtained device information, the image capturing apparatus 110 can extract, as selection candidates, analysis processing circuit data of classification 0001 and classification 0002. It is assumed that the image capturing apparatus 110 confirms that the selected analysis processing function is "P01". In this case, the image capturing apparatus 110 confirms the corresponding analysis processing flag of analysis processing circuit data of each selection candidate, and selects the analysis processing circuit of classification 0001 corresponding to the selected analysis processing function "P01". Furthermore, as the set values of the analysis processing corresponding to the analysis processing function P01, the image capturing apparatus 110 selects the set values of classification 001 and classification 002 as candidates. Assume that, for example, the image capturing conditions confirmed in step S2101 by the image capturing apparatus 110 give priority to the analysis processing speed. In this case, the image capturing apparatus 110 gives priority to the analysis processing time, and selects set values corresponding to classification 001. The control unit 304 of the image capturing apparatus reads out the determined analysis processing circuit data and the set values of analysis processing from the addresses of the storage unit 303 where these are stored, and transmits these to the detachable device 100. In the above-described way, the analysis processing circuit data and the set values of analysis processing are determined and provided to the detachable device 100.

Note that a plurality of set values can exist in correspondence with one analysis processing function. For example, in Fig. 20B, for the analysis processing function "P01", according to the set values of classification 002, an analysis processing accuracy of 99% can be obtained, but an analysis processing time of 500 msec is necessary. On the other hand, for the same analysis processing function "P01", according to the set values of classification 001, the analysis processing accuracy lowers to 80%, but the analysis processing time can be shortened to 100 msec. For example, assume that the analysis processing function "P01" is face authentication processing. If authentication accuracy is important from the viewpoint of security, the set values of classification 002 are appropriate. In a use case in which a similar person is detected from a plurality of persons in a limited time, the set values of classification 001 are appropriate. As described above, since the priority order changes in accordance with the purpose of the user, it may be demanded that set values considered as optimum solutions are initially set from limited choices, and the analysis processing function of the detachable device 100 is activated.

Each analysis processing circuit data is configured as circuit data capable of changing the analysis processing function by changing the analysis processing set values. Here, when a register structure that holds the set values of analysis processing configured in the analysis processing circuit is shared, different analysis processing set values can be set for the same analysis processing circuit. Also, it is possible to cause some different analysis processing circuits to execute the same analysis processing function by setting the same analysis processing set values. When the analysis processing circuit data and the analysis processing set values are configured in this way, the analysis processing set values associated with the analysis processing function can be shared by some analysis processing circuits. This can decrease the data amount of analysis processing circuit data and analysis processing set values that need to be held in the storage unit 303 of the image capturing apparatus 110.

The analysis processing circuit data may be selected based on the model number or the like of the detachable device 100 obtained from the device information. In this case, for example, the type and hardware configuration information of the detachable device 100 are listed in advance, and the hardware configuration information is stored in the storage unit 303 of the image capturing apparatus 110. Based on the model number of the detachable device 100 as the device information, the image capturing apparatus 110 can specify the connection configuration between the FPGA included in the detachable device 100 and peripheral circuits and constraint conditions.

The image capturing apparatus 110 may obtain analysis processing circuit data from the management apparatus 140 in advance. At the time of activation of the analysis processing function of the detachable device 100, the image capturing apparatus 110 first selects analysis processing circuit data and set values most appropriate for a designated application purpose. Note that if a specific analysis processing function is selected in advance by user designation, the image capturing apparatus 110 selects analysis processing circuit data capable of executing the designated analysis processing function. If selection of a specific analysis processing function is not determined in advance, the image capturing apparatus 110 can select analysis processing circuit data for which the number of selectable analysis processing functions is largest from analysis processing circuit data that can correspond to the FPGA. The selection priority order of analysis processing circuit data is not limited to this. For example, the priority order may be set such that analysis processing circuit data and set values for the highest analysis processing accuracy are selected. Other than this, the priority order may freely be set, or the priority order itself may be configured to be changeable. When analysis processing circuit data is determined, the image capturing apparatus 110 selects analysis processing set values corresponding to the analysis processing circuit data. The analysis processing set values can also be selected based on the priority order, like selection of analysis processing circuit data.

When the analysis processing function becomes executable in the detachable device 100, the image capturing apparatus 110 transmits the information of the selected analysis processing circuit data and analysis processing set values to the input/output apparatus 130. When the input/output apparatus 130 displays, on the display unit 703, the information of the selected analysis processing function based on the received information, the user can know the configuration information of the current detachable device 100 from the display unit 703 of the input/output apparatus 130. After the completion of activation of the analysis processing function in the detachable device 100, the image capturing apparatus 110 may transmit the information of the currently set analysis processing function to the management apparatus 140 as well. At this time, for example, if a more advanced analysis processing function concerning the same analysis processing exists, the image capturing apparatus 110 may obtain analysis processing circuit data and set values corresponding to the analysis processing function and update the analysis processing function of the detachable device 100.

In the above-described way, the image capturing apparatus 110 can determine the analysis processing function to be implemented by the detachable device 100. At this time, the analysis processing function can be changed in accordance with the application purpose of the image capturing apparatus 110. In addition, when the analysis processing circuit and the set values of corresponding analysis processing are managed on different tables, the table size can be reduced, and the storage capacity of the image capturing apparatus 110 can be prevented from being wasted. Also, when analysis processing set values according to an analysis processing function to be selected are set for analysis processing circuit data, the analysis processing function can be configured to be selectable.

The procedure of processing in the detachable device 100 will be described next. The device confirmation command is a command defined to request, by the image capturing apparatus 110, device information of the detachable device 100. As described above, the device confirmation command can include an analysis processing function confirmation request flag and a device information request flag in the command argument values. The analysis processing function confirmation request flag is a flag for inquiring about the existence of the logic circuit reconfiguration function capable of configuring an analysis processing function. The device information request flag is a flag for requesting transmission of device information. The detachable device 100 detects these pieces of flag information and performs control corresponding to the detected flag information. The detachable device 100 returns a device confirmation response to the device confirmation command. As described above, the device confirmation response can include, in the response argument values, an analysis processing function holding flag and an argument value representing device information. The analysis processing function holding flag is a flag representing whether the detachable device 100 has the logic circuit reconfiguration function capable of configuring an analysis processing function. For example, when the analysis processing function holding flag is set to " 1", it shows that the detachable device 100 has the logic circuit reconfiguration function. The argument value representing device information can be, for example, the model number of the device. Note that if the data amount of device information is large, the data size of device information may be set as the argument value of device information, and the image capturing apparatus 110 may be caused to issue a read command such that device information is transmitted via a data line.

Upon receiving the device confirmation command from the image capturing apparatus 110, the detachable device 100 determines the received command by the command determination unit 1801. Upon detecting the analysis processing function confirmation request flag, the command determination unit 1801 notifies the command control unit 1802 of the detection result. When the detection result representing that the analysis processing function confirmation request flag is detected is received, the command control unit 1802 returns the device confirmation response whose analysis processing function holding flag is set to "1" to the image capturing apparatus 110. On the other hand, upon detecting the device information request flag, the command determination unit 1801 issues a device information obtaining request to the processing switching unit 411. The processing switching unit 411 reads out information stored in the device information storage unit 1803, and transfers the readout information to the command control unit 1802. The command control unit 1802 transmits the device confirmation response including, in an argument value, the device information obtained from the processing switching unit 411 to the image capturing apparatus 110. Note that the command control unit 1802 may transmit the device confirmation response including, for example, the size of the device information to the image capturing apparatus 110, and cause the image capturing apparatus 110 to issue a read command. In this case, the command control unit 1802 may transmit the device information in response to the read command after the transmission of the device confirmation response. The device information storage unit 1803 can be formed by, for example, a storage element such as an EEPROM (Electrically Erasable Programmable Read-Only Memory). If the device information is formed by a limited information amount such as a model number, the device information storage unit 1803 may be configured to include, for example, a fuse circuit, and may thus be configured as a circuit that has an identifiable fixed value by disconnecting the fuse circuit at the time of shipment.

The analysis processing setting command is a command defined to write analysis processing circuit data in the detachable device 100 by the image capturing apparatus 110. The analysis processing setting command can include, for example, a circuit transmission flag, a set value transmission flag, and a circuit connection change flag in the command argument values. The circuit transmission flag is a flag representing a request of a write of analysis processing circuit data. The set value transmission flag is a flag representing a request of a write of the analysis processing set values. The circuit connection change flag is a flag representing a request of connection change of the SD I/F unit 205 of the detachable device. The image capturing apparatus 110 sets " 1" to each flag of the analysis processing setting command, thereby notifying data to be transmitted by the next write command. The size of data to be transmitted, and the like may be included in the argument values of the analysis processing setting command. Details of the circuit connection change flag will be described later. The detachable device 100 detects flag information, and performs control corresponding to the detected flag information.

The detachable device 100 transmits an analysis processing setting response to the analysis processing setting command to the image capturing apparatus 110. The analysis processing setting response can include, as the argument values, a circuit reception agreement flag, a circuit write completion flag, a set value reception agreement flag, a setting completion flag, a connection change agreement flag, and a connection change completion flag. When the detachable device 100 sets " 1" to each flag, the image capturing apparatus 110 can confirm the processing state of the detachable device 100.

When the detachable device 100 receives the analysis processing setting command from the image capturing apparatus 110, the command determination unit 1801 determines the received command.

Upon detecting the circuit transmission flag, the command determination unit 1801 notifies the processing switching unit 411 that the analysis processing circuit data is transmitted, and the processing switching unit 411 executes processing to set the FPGA 405 in a state in which circuit data can be written. When the FPGA 405 is set in the state in which circuit data can be written, the processing switching unit 411 outputs a preparation completion notification to the command control unit 1802. In accordance with the preparation completion notification, the command control unit 1802 transmits an analysis processing setting response in which the circuit reception agreement flag is set to " 1" to the image capturing apparatus 110. After that, in accordance with a write command from the image capturing apparatus 110, the input/output control unit 410 transfers the transmitted data (analysis processing circuit data) to the processing switching unit 411. The processing switching unit 411 converts the analysis processing circuit data as needed, and writes it in the FPGA 405. When the write of the analysis processing circuit data in the FPGA 405 is completed, the processing switching unit 411 notifies the command control unit 1802 of the write completion. Upon receiving the write completion notification from the processing switching unit 411, the command control unit 1802 sets, for example, the circuit write completion flag to "1". After that, upon receiving the analysis processing setting command from the image capturing apparatus 110, the command control unit 1802 returns an analysis processing setting response in which the circuit write completion flag is set to "1" to the image capturing apparatus 110. Note that during the time from the start of the write of circuit data to the write completion, the command control unit 1802 may transmit an instruction to the I/F unit 401 to drive the DATA signal line to the LOW state, thereby outputting a BUSY signal.

Upon detecting the set value transmission flag, the command determination unit 1801 notifies the input/output unit 1814 of the analysis processing circuit 1810 that the analysis processing set values are transmitted. The input/output unit 1814 makes a preparation to set a state in which the set values can be transmitted to the set value holding unit 1812. In accordance with the completion of the preparation, the input/output unit 1814 outputs a preparation completion notification to the command control unit 1802. Upon accepting the preparation completion notification from the input/output unit 1814, the command control unit 1802 transmits an analysis processing setting response in which the set value reception agreement flag is set to "1" to the image capturing apparatus 110. After that, in accordance with a write command from the image capturing apparatus 110, the input/output control unit 410 transfers transfer data (analysis processing set values) to the input/output unit 1814. The input/output unit 1814 writes the analysis processing set values in the set value holding unit 1812. When the write in the set value holding unit 1812 is completed, the input/output unit 1814 notifies the command control unit 1802 of the write completion. When the notification is received, the command control unit 1802 sets, for example, the set value write completion flag to "1". After that, upon receiving the analysis processing setting command from the image capturing apparatus 110, the command control unit 1802 returns an analysis processing setting response in which the set value write completion flag is set to "1" to the image capturing apparatus 110. Note that during the time from the start of the write of the analysis processing set values to the write completion, the command control unit 1802 may transmit an instruction to the I/F unit 401 to drive the DATA signal line to the LOW state, thereby outputting a BUSY signal.

In the above-described way, the analysis processing circuit data is written in the FPGA 405, and the analysis processing set values are written in the activated analysis processing circuit, thereby completing activation of the analysis processing function in the detachable device 100.

The analysis processing request command is a command defined to transmit, by the image capturing apparatus 110, an image before analysis processing to the detachable device 100 and request analysis processing. The analysis processing request command can include information of an image before analysis processing, an analysis processing request flag, and an analysis result request flag in the command argument values. The information of an image before analysis processing is information of an image as the target of analysis. The image as the target of analysis will be called an image before analysis processing. The analysis processing request flag is a flag representing that transfer data to be transmitted by the next write command is an image before analysis processing. The analysis result request flag is a flag representing a request of read of an analysis processing result. The size of data to be transmitted, and the like may be included in the argument values of the analysis processing request command. The detachable device 100 detects flag information and performs control corresponding to the detected function information.

Upon receiving the analysis processing request command from the image capturing apparatus 110, the detachable device 100 returns an analysis processing request response. The analysis processing request response can include an analysis processing request agreement flag, an analysis processing completion flag, and an analysis result read agreement flag in the response argument values. The detachable device 100 sets each flag to "1", thereby notifying the image capturing apparatus 110 of the processing state of the detachable device 100.

If the detachable device 100 receives the analysis processing request command from the image capturing apparatus 110, the command determination unit 1801 determines the received command.

Upon detecting the analysis processing request flag, the command determination unit 1801 notifies the input/output unit 1814 of the analysis processing circuit 1810 that the analysis processing request is received, and the input/output unit 1814 makes a preparation such that the arithmetic processing unit 1811 can accept an image before analysis processing. When the preparation is completed, the input/output unit 1814 outputs a preparation completion notification to the command control unit 1802. Upon receiving the preparation completion notification from the input/output unit 1814, the command control unit 1802 returns an analysis processing request response in which the analysis processing request agreement flag is set to "1" to the image capturing apparatus 110. After that, in accordance with a write command from the image capturing apparatus 110, upon receiving transfer data (an image before analysis processing), the input/output control unit 410 transfers the data to the input/output unit 1814. The input/output unit 1814 transfers the data to the arithmetic processing unit 1811. When data transfer to the arithmetic processing unit 1811 is started, the input/output unit 1814 notifies the command control unit 1802 of the start of analysis processing. The command control unit 1802 does not set the analysis processing completion flag to "1" until the analysis processing is completed. In this case, the image capturing apparatus 110 detects that the analysis processing completion flag is "0" in the analysis processing request response, thereby knowing that the analysis processing is being executed. Note that during the time from the start of analysis processing to the completion of analysis processing, the command control unit 1802 may transmit an instruction to the I/F unit 401 to drive the DATA signal line to the LOW state, thereby outputting a BUSY signal. After that, if the analysis processing is completed, the arithmetic processing unit 1811 notifies the input/output unit 1814 of the completion of analysis processing. In addition, the arithmetic processing unit 1811 transfers the analysis processing result to the input/output unit 1814. Upon receiving the analysis processing completion notification, the input/output unit 1814 transfers the analysis processing completion notification to the input/output control unit 410. In addition, the input/output unit 1814 transfers the analysis processing result to the arithmetic result holding unit 1815 via the input/output control unit 410, and the arithmetic result holding unit 1815 stores the analysis processing result. After that, the command control unit 1802 sets the analysis processing completion flag to "1". Hence, by receiving the analysis processing request response in which the analysis processing completion flag is "1", the image capturing apparatus 110 can know that the analysis processing is completed.

Upon detecting the analysis result request flag, the command determination unit 1801 notifies the arithmetic result holding unit 1815 that the analysis result request flag is received. Based on, for example, completion of analysis processing result storage processing, the arithmetic result holding unit 1815 outputs a preparation completion notification to the command control unit 1802. Upon receiving the preparation completion notification from the arithmetic result holding unit 1815, the command control unit 1802 returns an analysis processing request response in which the analysis result read agreement flag is set to "1" to the image capturing apparatus 110. When the image capturing apparatus 110 issues a read command, the input/output control unit 410 reads out the analysis processing result from the arithmetic result holding unit 1815 in accordance with the read command from the image capturing apparatus 110, and transfers it to the image capturing apparatus 110. In the above-described way, control is performed by the analysis processing request command such that analysis processing is executed in the detachable device 100, and the image capturing apparatus 110 can read out the analysis processing result from the detachable device 100.

Note that until the analysis processing completion flag is set to "1" in the detachable device 100, the arithmetic processing unit 1811 cannot accept analysis processing of a new image. For this reason, until a response in which the analysis processing completion flag is set to "1" is received, the image capturing apparatus 110 may confirm the state of the detachable device 100 by transmitting the analysis processing request command. In addition, the detachable device 100 may be configured to output a BUSY signal during execution of analysis processing. Note that even during execution of analysis processing in the detachable device 100, the image capturing apparatus 110 can read out an analysis processing result whose execution was completed in the past. Note that at this time, the arithmetic result holding unit 1815 may be configured to overwrite a new analysis processing result on an old analysis processing result when the new analysis processing result is input. In addition, the arithmetic result holding unit 1815 may be configured to hold a plurality of analysis processing results. In this case, for example, a serial number can be added to each analysis processing result. This allows the image capturing apparatus 110 to designate, by the serial number, which analysis processing result is to be read out. The number of the analysis processing result can be designated by including it in the command argument values of the analysis processing request command.

Note that the command determination unit 1801 of the input/output control unit 410 can be configured to, upon detecting a dedicated command concerning analysis processing, send an instruction only to the processing switching unit 411 without transferring the dedicated command to the SD controller 403. This can prevent the SD controller 403 from performing unnecessary control. On the other hand, upon receiving a command other than the dedicated command concerning analysis processing and data associated with the command, the input/output control unit 410 can directly transfer the command and data to the SD controller 403 without any special control. This allows the detachable device 100 to execute the normal storage processing function.

### (Processing Example 2)

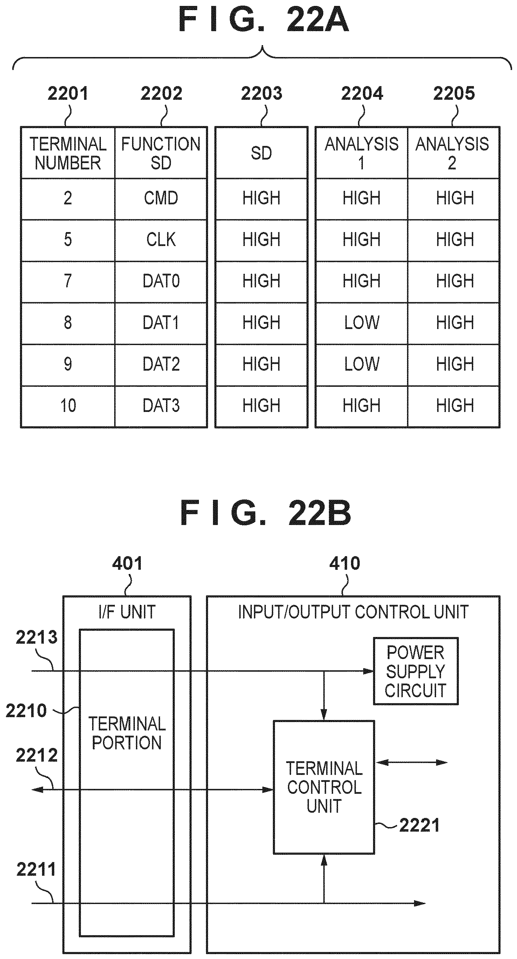

Another process of determining whether the detachable device 100 has a logic circuit reconfiguration function capable of configuring an analysis processing function will be described next. In this processing, the determination is executed by detecting terminal processing of the detachable device. Terminal processing of the detachable device will be described with reference to Figs. 22A and 22B. Fig. 22A shows the logic of the terminal portions of the SD I/F of the detachable device 100, and Fig. 22B shows the circuit arrangement of the I/F unit 401 of the detachable device 100.

A pin number 2201 in Fig. 22A indicates the pin number of a connecter terminal of the SD I/F. A function 2202 indicates the function of each terminal (pin) assigned by the SD standard. Pin 2 is command (CMD), pin 5 is clock (CLK), and pins 7 to 10 are data lines (DAT0 to DAT3). A terminal logic 2203 is the logic of each terminal at the time of execution of an initialization command (CMD0) when activating the device as an SD card. At this time, all communication terminals are set to High by a pull-up resistor. A terminal logic 2204 shows the logic of each communication terminal immediately after the detachable device 100 is powered on. A terminal logic 2205 shows the logic of each communication terminal after a clock 2211 is input to the detachable device 100. The terminal portions 2201 of the detachable device 100 other than CLK are configured to be pulled up when a power supply 2213 is turned on. DAT1 and DAT2 (data 2212) are set to Low by a terminal control unit 2221. After that, when the terminal control unit 2221 detects supply of the CLK 2211 from the image capturing apparatus 110, DAT1 and DAT2 that are Low are canceled, and the logic states of the remaining terminals are set to HIGH by the pull-up resistor in the image capturing apparatus 110. That is, in this embodiment, the detachable device 100 includes the terminal control unit 2221 if DAT1 and DAT2 can be set to Low after power supply and before supply of the CLK. Here, if the terminal control unit 2221 is employed only when the detachable device has the logic circuit reconfiguration function, the image capturing apparatus 110 can easily determine whether the detachable device 100 has the logic circuit reconfiguration function by monitoring DAT1 and DAT2.

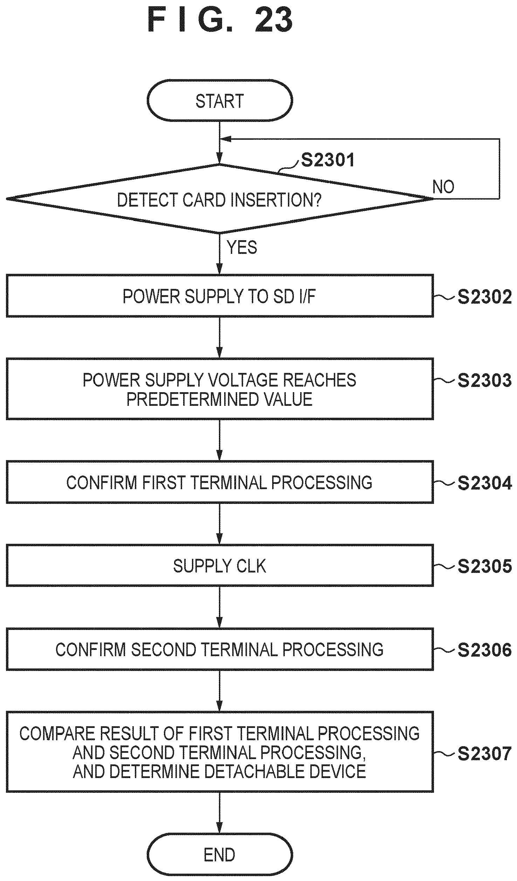

An example of the procedure of another process of determining, by the image capturing apparatus 110, whether the detachable device 100 has a logic circuit reconfiguration function will be described next with reference to Fig. 23. Upon detecting insertion of the detachable device 100 (YES in step S2301), the image capturing apparatus 110 supplies power to the detachable device 100 via the SD I/F unit 205 (step S2302). Upon detecting that the power supply voltage has reached a predetermined value, and the power supply has stabilized (step S2303), the image capturing apparatus 110 confirms first terminal processing, and confirms that the logic of each terminal is set to the state of the terminal logic 2204 (step S2304). Next, the image capturing apparatus 110 supplies the CLK 2211 (step S2305), and confirms second terminal processing (step S2306). At this time, each terminal logic detected by the image capturing apparatus 110 has the state of the terminal logic 2205. Upon detecting a change from the first terminal logic to the second terminal logic, the image capturing apparatus 110 determines that the detachable device 100 has the logic circuit reconfiguration function. As described above, the image capturing apparatus 110 confirms the states of the terminals of the SD I/F of the detachable device 100 via the SD I/F unit 205, thereby determining whether the detachable device 100 has the logic circuit reconfiguration function. In this method, it is possible to determine whether the detachable device 100 has the logic circuit reconfiguration function without performing communication complying with the SD standard.

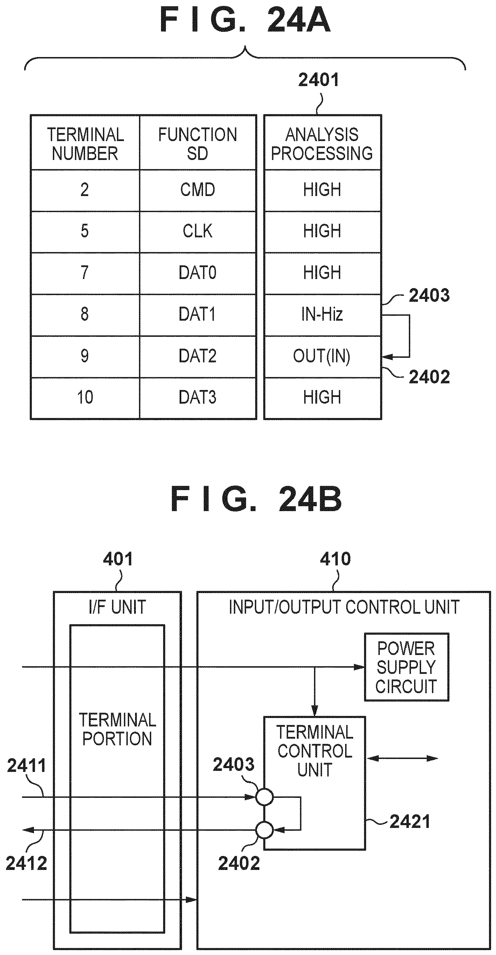

Still another process of determining whether the detachable device 100 has a logic circuit reconfiguration function will be described next. In this processing as well, the terminal processing of the detachable device 100 is detected, thereby determining whether the detachable device 100 has the logic circuit reconfiguration function. The terminal processing of the detachable device will be described with reference to Figs. 24A and 24B. Fig. 24A shows the logic of the terminal portions of the SD I/F of the detachable device 100 and connection signals, and Fig. 24B shows an example of the arrangement of the I/F unit 401 of the detachable device 100. Referring to Fig. 24A, a pin number indicates the pin number of a connecter terminal of the SD I/F. A function indicates the function of each terminal (pin) assigned by the SD standard. Pin 2 is command (CMD), pin 5 is clock (CLK), and pins 7 to 10 are data lines (DAT0 to DAT3). A terminal logic 2401 is the logic of each terminal before execution of an initialization command (CMD0) when activating the device as an SD card.

Here, a terminal 2403 of a terminal control unit 2421 is assigned to pin 8 of the SD I/F, and a terminal 2402 of the terminal control unit 2421 is assigned to pin 9 of the SD I/F. The terminal 2403 of the terminal control unit 2421 is set to an input terminal at the time of activation, and set to high impedance. The terminal 2402 of the terminal control unit 2421 is set to an output terminal at the time of activation, and is connected such that the input signal to the terminal 2403 is looped back to the terminal 2402 in the terminal control unit 2421. For this reason, if the signal input to the terminal 2403 matches the signal output from the terminal 2402, the detachable device includes the terminal control unit 2421. The terminal control unit 2421 can be employed only when the detachable device has the logic circuit reconfiguration function. Hence, the image capturing apparatus 110 can easily determine whether the detachable device 100 has the logic circuit reconfiguration function by monitoring whether the input signal to the terminal 2403 and the output signal from the terminal 2402 match with a shift of a predetermined delay time. Note that in the example shown in Figs. 24A and 24B, matching between the input signal to one terminal and the output signal from another terminal is determined. However, the present invention is not limited to this. That is, matching between input signals to some of a plurality of terminals and output signals from some other terminals of the plurality of terminals may be determined. Note that the number of input terminals and the number of output terminals need not match.

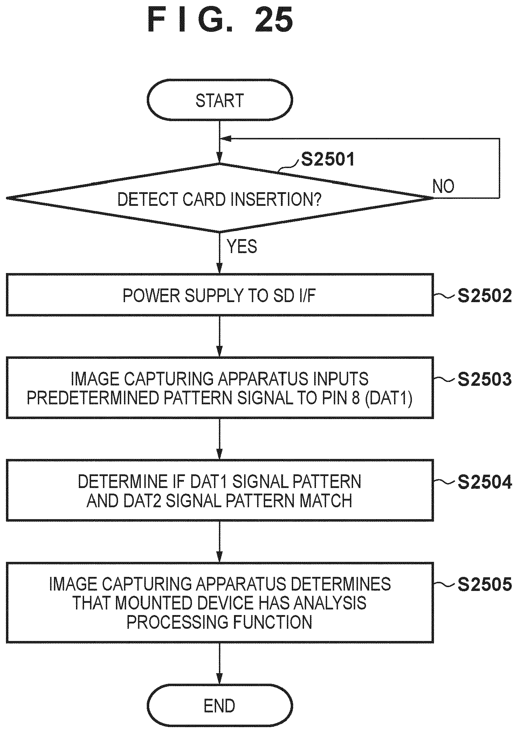

The procedure of still another process of determining, by the image capturing apparatus 110, whether the detachable device 100 has a logic circuit reconfiguration function will be described next with reference to Fig. 25. Upon detecting insertion of the detachable device 100 (YES in step S2501), the image capturing apparatus 110 supplies power to the detachable device 100 via the SD I/F unit 205 (step S2502). Upon detecting that the power supply has stabilized, the image capturing apparatus 110 inputs a signal of a predetermined pattern to a signal 2411 connected to pin 8 of the SD I/F (step S2503). The input signal pattern is sent from the terminal 2403 and output as a signal 2412 from the terminal 2402 to the image capturing apparatus 110. The image capturing apparatus 110 compares the output signal 2411 with the received signal 2412 (step S2504). Upon confirming that these signals are identical signals with a shift of a predetermined delay time, the image capturing apparatus 110 determines that the mounted detachable device 100 has the logic circuit reconfiguration function (step S2505). As described above, the image capturing apparatus 110 confirms the state of each terminal of the SD I/F of the detachable device 100 via the SD I/F unit 205, thereby determining whether the detachable device 100 has the logic circuit reconfiguration function. In this method, it can be determined whether the detachable device 100 has the logic circuit reconfiguration function without communication complying with the SD standard. Note that if the image capturing apparatus 110 does not input a signal to pin 8, the signals 2411 and 2412 are pulled up by the power supply. Hence, no operation error occurs even if the detachable device 100 is mounted in the image capturing apparatus 110 that does not support this processing.

### (Processing Example 3)

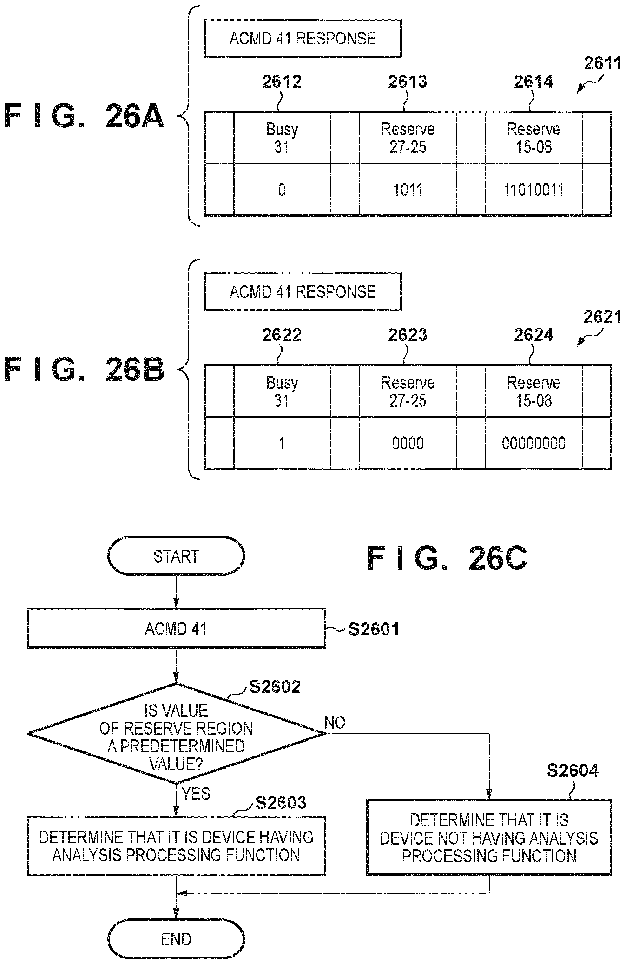

Processing of determining, based on the argument values of a response in the SD card initialization sequence, whether the detachable device 100 has a logic circuit reconfiguration function will be described next with reference to Figs. 26A to 26C. Figs. 26A and 26B each show the structure of a part of a response during the SD card initialization sequence. A response 2611 and a response 2621 represent two different states of an initialization command ACMD 41. A bit 2612 in the response 2611 and a bit 2622 in the response 2621 are bits representing a BUSY state. A bit 2613 and a bit 2614 in the response 2611 and a bit 2623 and a bit 2624 in the response 2621 are reserve bits. If the bit 2612 or the bit 2622 is "0" in the response of the initialization command ACMD 41, it is determined that the detachable device 100 is in the BUSY state, and remaining response argument parts are not processed as effective responses. On the other hand, if the bit 2612 or the bit 2622 is set to " 1 ", it is determined that the BUSY state of the detachable device 100 is canceled, and the arguments of the response 2611 and the response 2621 are recognized as the argument values of effective responses. The reserve bits are bits that are not defined as functions. Normally, the reserve bits store "0" and are neglected by the connected image capturing apparatus 110. On the other hand, in the response 2611, an argument value representing that the detachable device 100 has the logic circuit reconfiguration function is set in the reserve bits. Note that the response 2611 is handled as an invalid response in the SD standard because "0" is stored in the BUSY bit 2612. That is, in a form of an invalid response in the SD standard, the detachable device 100 notifies the image capturing apparatus 110 of information representing whether the detachable device 100 has the logic circuit reconfiguration function. On the other hand, in the response 2621, "1" is stored in the BUSY bit 2622, and "0" is stored in the reserve bits (the bit 2613 and the bit 2614), thereby representing that the BUSY state is canceled. The response 2621 is handled as a valid response complying with the SD standard.

An example of the procedure of processing will be described next with reference to Fig. 26C. Upon detecting mounting of the detachable device 100, the image capturing apparatus 110 performs SD card initialization processing between it and the detachable device 100. First, the image capturing apparatus 110 issues the ACMD 41 (step S2601), and discriminates the SD card. Upon detecting that a response from the SD controller 403 is the response of the ACMD 41, the command control unit 1802 of the detachable device 100 changes the values of the reserve bits in a state in which "0" is set in the BUSY bit. Here, an argument value "OxB" is set in the bit 2613, and an argument value "0xC3" is set in the bit 2614. The detachable device 100 then transmits the response 2611 to the image capturing apparatus 110 as a response to the received command.

Upon receiving the response in the BUSY state as the response to the ACMD 41, the control unit 304 of the image capturing apparatus 110 confirms values in a reserve region in the response. The image capturing apparatus 110 determines whether the values obtained from the reserve region of the response 2611 correspond to (match) a device code for identifying the detachable device, which is stored in the storage unit 303 in advance (step S2602). Here, assume that "0xBC3" is held as a device code in the storage unit 303. In this case, the image capturing apparatus 110 determines that the argument values "OxB" and "OxC3" obtained from the response 2611 correspond to the device code "0xBC3" held in the storage unit 303 (YES in step S2602). The image capturing apparatus 110 then determines that the mounted device has the logic circuit reconfiguration function (step S2603), and ends the processing. Note that the argument values "OxB" and "0xC3" are merely examples, and numerical values other than these can also be used, as a matter of course. On the other hand, upon determining that the argument values in the response 2611 do not correspond to the device code held in the storage unit 303 (NO in step S2602), the image capturing apparatus 110 determines that the mounted device has only the storage processing function (step S2604), and ends the processing. Note that in any case, the image capturing apparatus 110 directly continues the processing of the initialization processing as an SD card. When the BUSY state from the SD controller 403 is canceled, the detachable device 100 transmits the response 2621 to the image capturing apparatus 110. Upon detecting that" 1" is set in the bit 2622 of the response 2621, the image capturing apparatus 110 determines that the BUSY state is canceled, and confirms the argument values in the response 2621. After that, the image capturing apparatus 110 and the detachable device 100 can continuously process the initialization sequence as an SD card. The above-described processing can be executed if the detachable device is inserted/removed, or every time the device is powered on again. Note that, for example, if the write of analysis processing circuit data is not necessary, the detachable device 100 may set the argument value in the response in the BUSY state to a predetermined value different from the device code, thereby notifying the image capturing apparatus 110 of the state. This allows the image capturing apparatus 110 to specify that the detachable device 100 has the logic circuit reconfiguration function but is in a state in which the write of analysis processing circuit data is unnecessary. In addition, the detachable device 100 may be configured to change the argument value in the response in the BUSY state in accordance with the status of the self-device.

When supporting the analysis processing function, the image capturing apparatus 110 determines the values of the reserve bits of the response in the BUSY state, thereby detecting that the detachable device 100 has the logic circuit reconfiguration function, and the write of analysis processing circuit data is necessary. In the above-described way, the image capturing apparatus 110 can determine, using the response during the BUSY state, whether the detachable device 100 has the logic circuit reconfiguration function. On the other hand, if the analysis processing function is not supported, the image capturing apparatus 110 detects, based on the BUSY bit, that the detachable device 100 is in the BUSY state, and neglects the argument values in the response. As a result, the image capturing apparatus 110 that does not support the analysis processing function can handle the detachable device 100 like a normal SD card having only the storage processing function.

### (Other Processing Examples)

Note that the processing of the image capturing apparatus 110 to write analysis processing circuit data in the detachable device 100 can be executed by an arrangement different from the arrangement as described above. The processing will be described below.

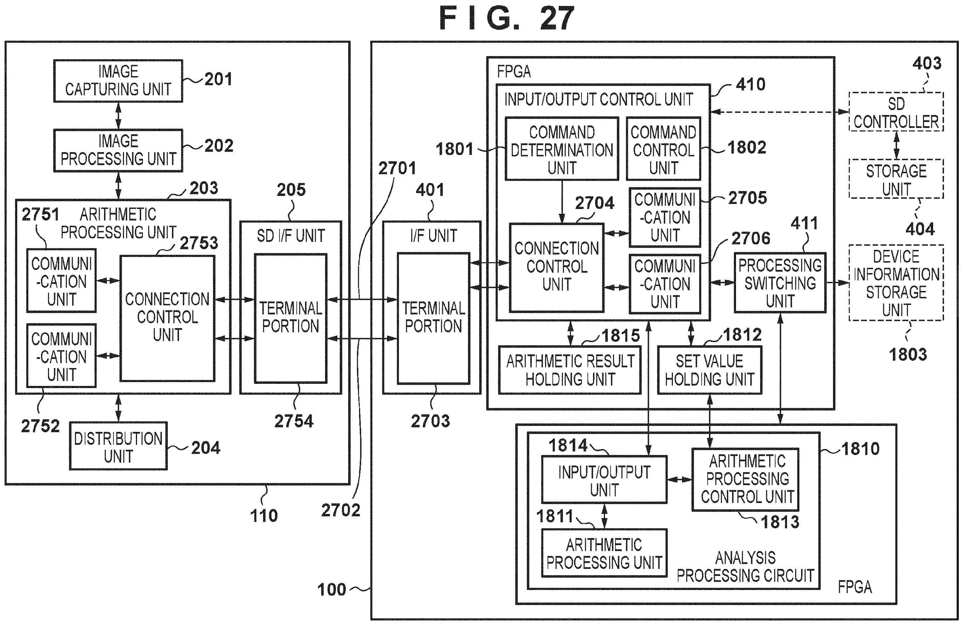

Fig. 27 shows examples of arrangements of the image capturing apparatus 110 and the detachable device 100. The same reference numerals as in the arrangement example of the image capturing apparatus 110 shown in Fig. 2 and the arrangement example of the detachable device 100 shown in Fig. 18 denote common components, and a description thereof will be omitted.

The arithmetic processing unit 203 of the image capturing apparatus 110 includes, for example, a communication unit 2751, a communication unit 2752, and a connection control unit 2753. In addition, the SD I/F unit 205 of the image capturing apparatus 110 includes a terminal portion 2754. The communication unit 2751 is a communication unit corresponding to the SD controller. The communication unit 2752 is a communication unit different from the communication unit 2751, and corresponds to a protocol other than the SD protocol. The connection control unit 2753 switches between the communication unit 2751 and the communication unit 2752 concerning electrical connection to the terminal portion 2754. The terminal portion 2754 is a terminal portion of a connector corresponding to the SD I/F. If an instruction from the control unit 304 is received and, for example, connection to the communication unit 2751 is selected, the connection control unit 2753 executes control to connect the communication line of the communication unit 2751 to the terminal portion 2754. Similarly, if connection to the communication unit 2752 is selected, the connection control unit 2753 executes control to connect the communication line of the communication unit 2752 to the terminal portion 2754. Note that the connection control unit 2753 may execute control to simultaneously connect the communication unit 2751 and the communication unit 2752 to the terminal portion 2754. In this case, for example, which one of the communication unit 2751 and the communication unit 2752 should be connected is selected for each terminal of the terminal portion 2754, and the connection control unit 2753 executes connection control based on the selection.

The input/output control unit 410 of the detachable device 100 includes, for example, a connection control unit 2704, a communication unit 2705, and a communication unit 2706 in addition to arrangement shown in Fig. 18. Also, the I/F unit 401 of the detachable device 100 includes, for example, a terminal portion 2703 in addition to the arrangement shown in Fig. 18. The communication unit 2705 and the communication unit 2706 are communication units configured to communicate with the image capturing apparatus 110. These are configured to be operable independently and correspond to the SD standard and a communication protocol other than that. The terminal portion 2703 is a terminal portion of a connector corresponding to the SD I/F. The connection control unit 2704 executes control to connect at least one of the communication unit 2705 and the communication unit 2706 to the terminal portion 2703. The connection control unit 2704 executes control of selecting at least one of connection from the terminal portion 2703 to the communication unit 2705 and connection from the terminal portion 2703 to the communication unit 2706 based on the determination result of the command determination unit 1801 and switching the connection. Upon selecting use of the communication unit 2705, the connection control unit 2704 executes control such that all signal lines of the terminal portion 2703 are connected to the communication unit 2705. On the other hand, upon selecting use of the communication unit 2706, the connection control unit 2704 executes control such that all signal lines of the terminal portion 2703 are connected to the communication unit 2706. It is also possible to simultaneously connect the communication unit 2705 and the communication unit 2706 to the terminal portion 2703. In this case, the connection control unit 2704 selects which one of the communication unit 2705 and the communication unit 2706 should be connected for each terminal of the terminal portion 2703, and executes connection control in accordance with the selection result. In the arrangement shown in Fig. 27, the set value holding unit 1812 is included in the FPGA 402. In this arrangement, the image capturing apparatus 110 and the detachable device 100 are connected via at least one of the two communication units.

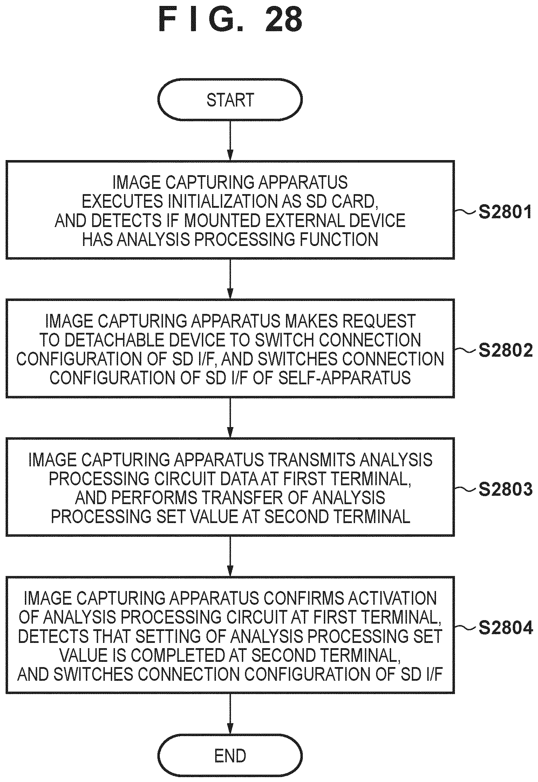

An example of the procedure of processing when, in a case in which the arrangement as described above is used, the detachable device 100 is mounted in the image capturing apparatus 110, and analysis processing circuit data and set values of analysis processing are written in the detachable device 100 will be described next. In this processing, the SD card initialization sequence is executed using a communication line 2701 and a communication line 2702 shown in Fig. 27. After that, analysis processing circuit data is transferred using the first communication line 2701, and the analysis processing set values are transferred using the second communication line 2702. Fig. 28 shows an example of the procedure of this processing.

First, upon detecting mounting of the detachable device 100, the image capturing apparatus 110 executes SD card initialization processing. The image capturing apparatus 110 obtains device information from the detachable device 100, and detects that the detachable device 100 has a logic circuit reconfiguration function capable of configuring an analysis processing function (step S2801). The detachable device discrimination method or the device information obtaining method can be executed by one of the methods of the above-described embodiment, and a description thereof will be omitted here. Next, the image capturing apparatus 110 requests the detachable device 100 to switch terminal connection of the SD I/F (step S2802). Whether the detachable device 100 can switch terminal connection can be determined based on, for example, the obtained device information. The image capturing apparatus 110 generates, for example, an analysis processing setting command in which the circuit connection change flag is set to "1", and the connection method is included in the command argument values, and transmits the command to the detachable device 100. Upon receiving the analysis processing setting command from the image capturing apparatus 110, the command determination unit 1801 of the detachable device 100 detects the circuit connection change flag included in it, and executes connection control (step S2802). First, the command determination unit 1801 makes a notification to the connection control unit 2704. The command determination unit 1801 also makes a notification to the communication unit 2705 and the communication unit 2706, and executes a preparation such that the communication unit 2705 can receive the analysis processing circuit data, and the communication unit 2706 can receive the analysis processing set values. In addition, the command determination unit 1801 sends a notification to the processing switching unit 411, and the processing switching unit 411 makes a preparation for writing the analysis processing circuit data from the communication unit 2705 in the FPGA 405. The command determination unit 1801 also makes a notification to the set value holding unit 1812, and executes a preparation such that the analysis processing set values can be stored. The command control unit 1802 generates an analysis processing setting response in which the connection change agreement flag is set to "1", and returns it to the image capturing apparatus 110.

The connection control unit 2704 controls the connection destination such that the connection method designated by the command argument value is used. Details of terminal connection will be described later. When connection setting by the connection control unit 2704 is completed, the command control unit 1802 sets the connection change completion flag to "1". If an analysis processing setting command is received again in this state, the detachable device 100 returns an analysis processing setting response in which the connection change completion flag is set to "1" to the image capturing apparatus 110. The command control unit 1802 may simultaneously set the connection change agreement flag and the connection change completion flag to "1". In this case, a notification representing that the connection change is agreed, and the connection change is completed can be made by transmitting the analysis processing setting response once. Upon receiving an analysis processing setting response in which the connection change agreement flag is not to set to "1" from the detachable device 100, the image capturing apparatus 110 can recognize that the terminal connection cannot be changed in the detachable device 100. Upon detecting the connection change completion flag of the analysis processing setting response, the connection control unit 2753 of the image capturing apparatus 110 changes the connection. At this time, the communication unit 2752 of the image capturing apparatus 110 and the communication unit 2705 of the detachable device 100 are communicably connected via the first terminal connection between the terminal portion 2754 and the terminal portion 2703, and the communication unit 2751 and the communication unit 2706 are communicably connected via the second terminal connection.

Next, the image capturing apparatus 110 transmits the determined analysis processing circuit data and the analysis processing set values. The image capturing apparatus 110 transmits the analysis processing circuit data from the communication unit 2751, and transmits the analysis processing set values from the communication unit 2752 (step S2803). The communication unit 2705 of the detachable device 100 sends the received analysis processing circuit data to the processing switching unit 411, and the processing switching unit 411 writes the analysis processing circuit data in the FPGA 405. The communication unit 2706 transmits the received analysis processing set values to the set value holding unit 1812, and the set value holding unit 1812 stores the received analysis processing set values. Note that the image capturing apparatus 110 can transmit, in advance, an analysis processing setting command including, as the argument values, the data size of the analysis processing circuit data as the transmission target and the data size of the analysis processing set values. The data sizes may be transmitted divisionally a plurality of times by a plurality of separate commands, or may be transmitted via a data line by a write command. When the transmission of the analysis processing circuit data and the analysis processing set values is completed, the image capturing apparatus 110 changes the connection of the connection control unit 2753 again. The initially connected communication unit is connected to the terminal portion 2754. Upon detecting that the received data size matches the argument value in the analysis processing setting command, the command determination unit 1801 of the detachable device 100 makes a notification to the connection control unit 2704 and the command control unit 1802. The connection control unit 2704 connects the communication unit connected in the initial state to the terminal portion 2703. The connection change of the SD I/F is thus completed (step S2804).

The command control unit 1802 sets the setting completion flag in the analysis processing setting response to "1". The image capturing apparatus 110 transmits the analysis processing setting command again, and detects that the setting completion flag set to "1" is included in the analysis processing setting response, thereby specifying that the activation of the analysis processing function is completed and ending the processing. The activation of analysis processing is thus completed in the detachable device.

According to the arrangement shown in Fig. 27, since the set value holding unit 1812 is formed outside the FPGA 405, analysis processing circuit data and analysis processing set values can simultaneously be transferred. Even if the clock frequency cannot be raised at the time of the write of circuit data in the FPGA 405, the activation time of the analysis processing function can be shortened by simultaneously writing analysis processing circuit data and analysis processing set values.

The completion of data transfer from the image capturing apparatus 110 can be determined by setting an end flag at the end of transfer data. In addition, after the circuit connection change is completed, the detachable device 100 may notify that the write in the FPGA is completed by outputting a BUSY signal. The connection change may be requested by a method other than the analysis processing setting command. For example, the connection change may be requested by communication in the SPI (Serial Peripheral Interface) mode, I2C (Inter-Integrated Circuit) communication, or communication by another unique protocol. Each of the arithmetic result holding unit 1815 and the set value holding unit 1812 may be arranged outside the FPGA402 and formed by, for example, a storage element such as a RAM

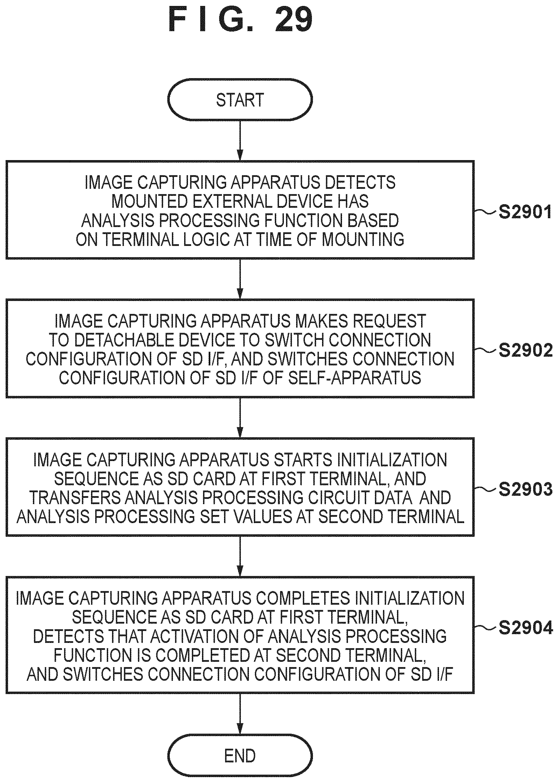

An example of the procedure of processing of performing the SD initialization sequence by a command using the first communication line 2701 and transferring analysis processing circuit data using the second communication line 2702 will be described next with reference to Fig. 29. Note that a description of the same contents as the processing shown in Fig. 28 will be omitted.

The image capturing apparatus 110 detects, based on the terminal logic at the time of mounting, that the mounted device has the analysis processing function (step S2901). The image capturing apparatus 110 requests the detachable device to switch the connection configuration of the SD I/F, and also switches the connection configuration of the SD I/F of the self-apparatus (step S2902). The image capturing apparatus starts the initialization sequence as an SD card at the first terminal, and transfers analysis processing circuit data and analysis processing set values at the second terminal (step S2903). Upon detecting that the initialization sequence as an SD card is completed at the first terminal, and the activation of the analysis processing function is completed at the second terminal, the image capturing apparatus 110 switches the connection configuration of the SD I/F (step S2903).

The communication rate at the time of the initialization sequence of the SD card is limited. For this reason, time is needed to transfer data until the initialization sequence of the SD card is completed. On the other hand, according to this processing, the analysis processing function can be activated by transferring analysis processing set values and the like in parallel to initialization of the SD card. Hence, in the detachable device 100, the time until the analysis processing function is activated can be shortened. Even if the SD controller is in the BUSY state, analysis processing circuit data can be transferred without any influence on the SD controller. In this processing, analysis processing circuit data is transferred by a communication unit different from communication by a command line. Hence, since analysis processing circuit data can be transferred using a frequency different from that of the command line, the write time of analysis processing circuit data can be shortened.

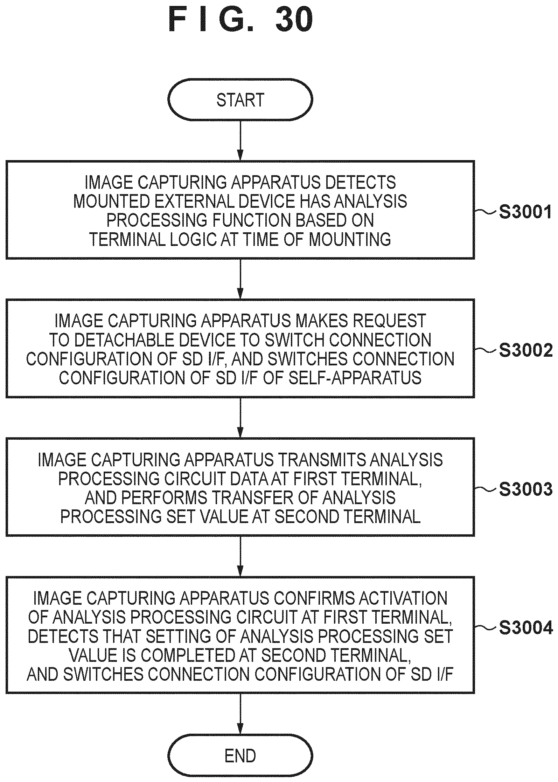

An example of the procedure of processing in the arrangement of the detachable device 100 shown in Fig. 27, which does not include the SD controller 403 and the storage unit 404, will be described next with reference to Fig. 30. In this processing, the device is determined by terminal processing. Analysis processing circuit data is transferred using the first communication line 2701, and analysis processing set values are transferred using the second communication line 2702.

First, the image capturing apparatus 110 detects, based on the terminal logic at the time of mounting, that the mounted device has the analysis processing function (step S3001). The image capturing apparatus 110 requests the detachable device 100 to switch the connection configuration of the SD I/F, and switches the connection configuration of the SD I/F of the self-apparatus (step S3002). The image capturing apparatus 110 and the detachable device 100 control connection between communication units by the connection control unit 2753 and the connection control unit 2704 such that analysis processing circuit data is transmitted by the first terminal, and analysis processing set values are transferred by the second terminal (step S3003). Upon confirming the activation of the analysis processing circuit at the first terminal, and detecting that the setting of the analysis processing set values is completed at the second terminal, the image capturing apparatus 110 switches the connection configuration of the SD I/F (step S3004). The activation of the analysis processing function is thus completed in the detachable device 100. According to this processing, the time until the analysis processing function is activated in the detachable device 100 can be shortened by simultaneously transmitting analysis processing circuit data and analysis processing set values. Note that the detachable device 100 may be configured such that communication by the SD command can be performed by the input/output control unit 410 even if the device does not have the storage processing function as an SD card. On the other hand, since the detachable device 100 does not have the SD controller, communication such as SPI may be used, or an SDIO (Secure Digital Input/Output) command may be used. A unique communication method may be used.

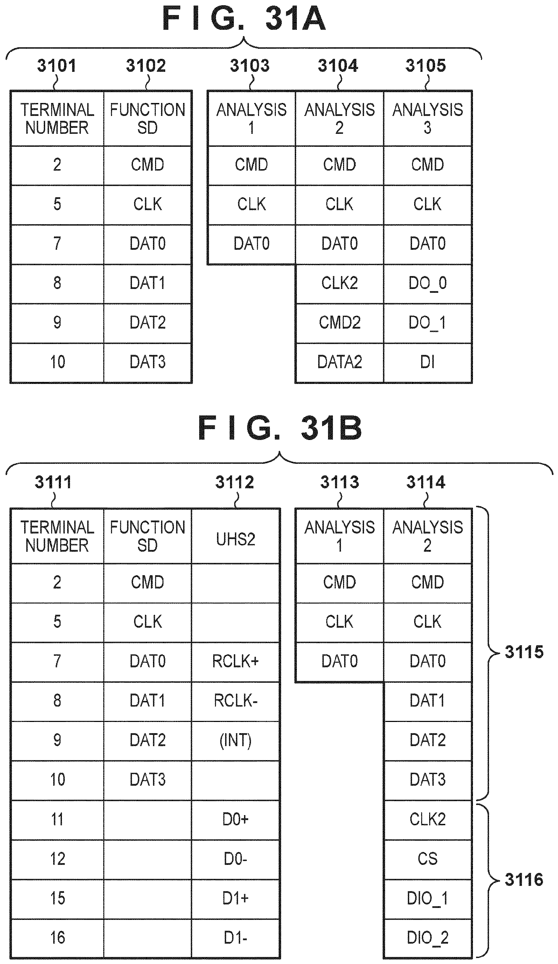

An example of signals connected to the terminal portion 2754 and the terminal portion 2703 will be described here with reference to Figs. 31A and 31B. Fig. 31A shows an example in a case of normal SD card terminals, and Fig. 31B shows an example in a case in which a transfer configuration of UHS (Ultra High Speed) 2 is used in the terminal portion of the detachable device 100.

A terminal number 3101 shown in Fig. 31A is the terminal number of an SD connector. A connection configuration 3102 shows a signal connected to each terminal when performing communication in the 4-bit mode of the SD card. A connection configuration 3103 shows a terminal used as the time of the initialization sequence of the SD card. Here, a command line, a clock line, and DAT0 are used as BUSY signals. A connection configuration 3104 shows a state in which the terminal connection of the image capturing apparatus 110 is changed. CMD, CLK, and DAT0 are first terminal connection, and CLK2, CMD2, and DATA2 are second terminal connection. In the first terminal connection, communication by the command line is performed. In parallel, at the second connection terminal, communication can be performed at the clock CLK2 different from the first connection terminal. For example, the terminal connection can be changed to this terminal connection in the processes shown in Figs. 28 and 29. A connection configuration 3105 shows a state in which the terminal connection of the image capturing apparatus 110 is changed. CMD, CLK, and DAT0 are first terminal connection, and CLK, DO_0, DO_1, and DI are second terminal connection. In this connection configuration, communication by the first terminal connection and communication by the second terminal connection are executed using the same clock line CLK. In the first terminal connection, data output is done at one terminal DAT0. On the other hand, in the second terminal connection, data output is done at two terminals DO_0 and DO_1. Hence, a twice higher transfer rate can be obtained. Note that DI is an input signal terminal.

A terminal number 3111 shown in Fig. 31B is the terminal number of an SD connector corresponding to UHS2. A connection configuration 3114 shows the connection configuration of the detachable device in a case in which UHS2 is not selected in the initialization sequence. A terminal group 3115 represents signal connection for the SD card. A terminal group 3116 represents a state in which 2-bit SPI communication is assigned to terminal numbers 11 to 16 that are unused terminals.

In the connection configuration 3114, circuit data is written by the terminal group 3115 at the time of activation, and on the other hand, analysis processing set values can be written by the terminal group 3116. Transmission data assignment to the terminal group 3115 and the terminal group 3116 is not limited to this, and another combination of data transmissions may be used. Also, after the completion of initialization processing, an analysis processing circuit can be written by the terminal group 3116 while performing a captured image recording processing operation by the terminal group 3115.

Thus, the constraints of timing of rewriting the analysis processing circuit can largely be reduced by appropriately setting the connection configuration. Note that these are merely examples, and assignment of another combination to the terminals may be used. In this embodiment, a communication configuration by two terminal connections has been described. However, terminal connections more than two, for example, three or four terminal connections may be used.

As described above, since the detachable device 100 can be accessed by the SD protocol, the detachable device 100 with high I/F compatibility can be implemented. The detachable device can be mounted in the image capturing apparatus 110 of a different application purpose. In addition, the image capturing apparatus 110 can write circuit data in an appropriate device by discriminating the attached/detached device. Also, the image capturing apparatus 110 can prevent communication such as a circuit data write from being unnecessarily performed for the device by determining that the mounted device does not have the logic circuit reconfiguration function capable of configuring an analysis processing function.

When the image capturing apparatus 110 selects processing that is not provided in the self-apparatus and writes analysis processing circuit data in the detachable device 100, analysis processing can appropriately be executed. When the image capturing apparatus 110 detects mounting of the detachable device 100 and automatically writes analysis processing circuit data, the processing function can easily be activated without performing a setting operation by the user.

If the image capturing apparatus 110 cannot obtain the configuration information of the device, an operation error may occur depending on written circuit data. However, the image capturing apparatus 110 can select appropriate circuit data according to the FPGA of the detachable device 100 by obtaining the hardware configuration information of the detachable device 100. Also, the configuration of the detachable device can freely be selected by discriminating the mounted device by a method that does not comply with the SD standard. Furthermore, when terminal connection is changed in the data transmission method, a plurality of data transmissions can be executed in parallel, and the time until activation of analysis processing can be shortened.

Note that in the above-described embodiment, an example in a case in which the device is mounted in the mounting part of the image capturing apparatus 110, which complies with the SD standard, has been described. However, the present invention is not limited to this. That is, the above-described argument can be applied in a case in which an external device is mounted in the mounting part with an arbitrary form in an arbitrary electronic device. A similar argument can also be applied in a case in which a mounting part usable by a predetermined standard other than the SD standard is used.

Additionally, in the above-described embodiment, upon determining that the mounted device has the logic circuit reconfiguration function, the image capturing apparatus 110 determines circuit data to be provided to the device based on the device information of the device. However, the present invention is not limited to this. For example, in some cases, one circuit data exists for certain processing independently of the arrangement of a device. In this case, upon determining that the processing is selected, and the mounted device has the logic circuit reconfiguration function, the image capturing apparatus 110 can determine the circuit data to be provided without depending on the device information of the device.

### Other Embodiments

Embodiments) of the present invention can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiments) and/or that includes one or more circuits (e.g., application specific integrated circuit (ASIC)) for performing the functions of one or more of the above-described embodiments), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiments). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. An image capturing apparatus (110), which includes a mounting part (205) capable of attaching/detaching a device (100) capable of storing at least a captured image, determines, if a device capable of configuring a logic circuit corresponding to analysis processing for data obtained by the image capturing apparatus is mounted in the mounting part, circuit data used to configure the logic circuit of the device based on device information concerning the device, and transmits the determined circuit data to the device.

## Claims

1. An image capturing apparatus (110) including a mounting part (205) capable of attaching/detaching a device (100) capable of storing at least a captured image, comprising:
first determination means (304) for, if a device capable of configuring a logic circuit corresponding to analysis processing for data obtained by the image capturing apparatus is mounted in the mounting part, determining, based on device information concerning the device, circuit data used to configure the logic circuit of the device; and
transmission means (306) for transmitting the determined circuit data to the device.

2. The apparatus according to claim 1, further comprising second determination means for determining whether the device can configure the logic circuit corresponding to the analysis processing.

3. The apparatus according to claim 2, wherein the second determination means determines, based on the device information, whether the device can configure the logic circuit corresponding to the analysis processing.

4. The apparatus according to any one of claims 1 to 3, wherein the device information includes information concerning configuration means included in the device and capable of configuring the logic circuit corresponding to the analysis processing.

5. The apparatus according to any one of claims 1 to 4, further comprising obtaining means for transmitting a command for requesting the device information from the device and obtaining, from the device, the device information by an argument value of a response to the command.

6. The apparatus according to any one of claims 1 to 5, wherein if the device can configure the logic circuit corresponding to the analysis processing by a field programmable gate array (FPGA), the device information includes information representing at least one of hardware configuration information of the device, information of a type of the FPGA, constraint information of a logic circuit configuration, terminal connection information, and information of a peripheral circuit, or information capable of specifying at least one of the hardware configuration information of the device, the information of the type of the FPGA, the constraint information of the logic circuit configuration, the terminal connection information, and the information of the peripheral circuit.

7. The apparatus according to claim 2, wherein the mounting part has an arrangement corresponding to a predetermined standard, and
the second determination means transmits, via the mounting part, a command that is not a command of the predetermined standard, and determines, based on whether a response is received, whether the device can configure the logic circuit corresponding to the analysis processing.

8. The apparatus according to claim 2, wherein the mounting part is configured to include a plurality of terminals, and
the second determination means determines states of the plurality of terminals, thereby determining whether the device can configure the logic circuit corresponding to the analysis processing.

9. The apparatus according to claim 8, wherein the second determination means determines, based on states of some of the plurality of terminals after a start of supply of power to the device until supply of a clock to the device, whether the device can configure the logic circuit corresponding to the analysis processing.

10. The apparatus according to claim 8, wherein the second determination means compares a pattern of an input signal to some of the plurality of terminals with a pattern of an output signal to some other terminals of the plurality of terminals, thereby determining whether the device can configure the logic circuit corresponding to the analysis processing.

11. The apparatus according to any one of claims 1 to 10, wherein the first determination means determines the circuit data based on processing to be executed by the device.

12. The apparatus according to any one of claims 1 to 11, wherein the first determination means determines the circuit data based on information concerning the image capturing apparatus.

13. The apparatus according to claim 12, wherein the information concerning the image capturing apparatus includes information representing at least one of a size, color difference/color space information, an image format, and the number of quantization bits of image data for which the image capturing apparatus causes the device to execute analysis processing, or information capable of specifying at least one of the size, the color difference/color space information, the image format, and the number of quantization bits of teg image data for which the image capturing apparatus causes the device to execute analysis processing.

14. The apparatus according to claim 12 or 13, wherein the information concerning the image capturing apparatus includes information representing at least one of power that the image capturing apparatus can supply, an operation condition of the image capturing apparatus, and a communication rate, or information capable of specifying at least one of the power that the image capturing apparatus can supply, the operation condition of the image capturing apparatus, and the communication rate.

15. The apparatus according to any one of claims 1 to 14, further comprising holding means for holding the circuit data that can be supplied to the device,
wherein the transmission means obtains the determined circuit data from the holding means and transmits the circuit data to the device.

16. The apparatus according to any one of claims 1 to 14, further comprising means for obtaining the circuit data determined by the first determination means from an apparatus different from the image capturing apparatus and the device,
wherein the transmission means transmits the obtained circuit data to the device.

17. The apparatus according to any one of claims 1 to 16, wherein the mounting part is configured to include a plurality of terminals, and
the image capturing apparatus further comprises setting means for setting signals to be connected to the plurality of terminals such that a plurality of communications are performed in parallel with the device using the plurality of terminals.

18. The apparatus according to claim 17, wherein the setting means sets the signals to be connected to the plurality of terminals such that initialization processing of the device is executed using a first terminal of the plurality of terminals, and the circuit data is transmitted to the device using a second terminal of the plurality of terminals.

19. The apparatus according to claim 17, wherein the circuit data includes information of a circuit configured in the device and information of a set value, and
the setting means sets the signals to be connected to the plurality of terminals such that the information of the circuit is transmitted to the device using a first terminal of the plurality of terminals, and the information of the set value is transmitted to the device using a second terminal of the plurality of terminals.

20. A device (100) mounted in an image capturing apparatus (110) including a mounting part capable of attaching/detaching the device capable of storing at least a captured image, comprising:
configuration means (411) capable of configuring a logic circuit corresponding to analysis processing for data obtained from the image capturing apparatus; and
execution means (401) for, if the device is mounted in the image capturing apparatus, executing communication that allows the image capturing apparatus to specify that the device includes the configuration means,
wherein if circuit data is obtained from the image capturing apparatus based on the communication, the configuration means configures the logic circuit based on the circuit data.

21. The device according to claim 20, wherein as the communication, the execution means transmits device information concerning the device.

22. The device according to claim 21, wherein the device information includes information concerning the configuration means.

23. The device according to claim 21 or 22, wherein if a command for requesting the device information is received from the image capturing apparatus, the execution means transmits the device information as an argument value of a response to the command.

24. The device according to any one of claims 21 to 23, wherein the configuration means is a field programmable gate array (FPGA), and
the device information includes information representing at least one of hardware configuration information of the device, information of a type of the FPGA, constraint information of a logic circuit configuration, terminal connection information, and information of a peripheral circuit, or information capable of specifying at least one of the hardware configuration information of the device, the information of the type of the FPGA, the constraint information of the logic circuit configuration, the terminal connection information, and the information of the peripheral circuit.

25. The device according to claim 20, wherein the device comprises an arrangement corresponding to a predetermined standard corresponding to the mounting part, and
as the communication, if a command that is not a command of the predetermined standard is received via the mounting part, the execution means transmits a response.

26. The device according to claim 20, wherein as the communication, the execution means changes states of some of a plurality of terminals corresponding to the mounting part after a start of supply of power from the image capturing apparatus until supply of a clock, and causes the image capturing apparatus to specify the states.

27. The device according to claim 20, wherein as the communication, the execution means outputs a pattern input to some of a plurality of terminals corresponding to the mounting part from some other terminals of the plurality of terminals.

28. The device according to any one of claims 20 to 27, further comprising means for setting signals to be connected to the plurality of terminals such that a plurality of communications are performed in parallel with the image capturing apparatus using the plurality of terminals corresponding to the mounting part.

29. The device according to claim 28, wherein the means for setting the signals to be connected to the plurality of terminals sets the signals to be connected to the plurality of terminals such that communication for initialization processing of the device is executed using a first terminal of the plurality of terminals, and the circuit data is received from the image capturing apparatus using a second terminal of the plurality of terminals.

30. The device according to claim 28, wherein the circuit data includes information of a circuit configured in the device and information of a set value, and
the means for setting the signals to be connected to the plurality of terminals sets the signals to be connected to the plurality of terminals such that the information of the circuit is received from the image capturing apparatus using a first terminal of the plurality of terminals, and the information of the set value is received from the image capturing apparatus using a second terminal of the plurality of terminals.

31. The device according to any one of claims 20 to 30, further comprising storage means capable of storing the data obtained from the image capturing apparatus.

32. The device according to claim 31, further comprising determination means for determining, based on data received from the image capturing apparatus, to which one of the storage means and setting means for doing setting of the configuration means the data is to be transferred.

33. The device according to any one of claims 21 to 24, further comprising storage means capable of storing the data obtained from the image capturing apparatus,
wherein the device information is stored in the storage means, and
the execution means transmits the device information to the image capturing apparatus in accordance with a request of read of the device from the image capturing apparatus.

34. The device according to any one of claims 20 to 33, wherein the device does not comprise nonvolatile storage means for holding the circuit data.

35. A control method executed by an image capturing apparatus (110) including a mounting part (205) capable of attaching/detaching a device (100) capable of storing at least a captured image, comprising:
if a device capable of configuring a logic circuit corresponding to analysis processing for data obtained by the image capturing apparatus is mounted in the mounting part, determining (S805), based on device information concerning the device, circuit data used to configure the logic circuit of the device; and
transmitting (S805) the determined circuit data to the device.

36. A control method executed by a device (100) mounted in an image capturing apparatus (110) including a mounting part (205) capable of attaching/detaching the device capable of storing at least a captured image and including configuration means capable of configuring a logic circuit corresponding to analysis processing for data obtained from the image capturing apparatus, comprising:
if the device is mounted in the image capturing apparatus, executing communication that allows the image capturing apparatus to specify that the device includes the configuration means; and
if circuit data is obtained from the image capturing apparatus based on the communication, configuring the logic circuit based on the circuit data.

37. A program configured to cause a computer to execute a control method described in claim 35 or 36.
